# EUROPEAN PATENT APPLICATION

(11) **EP 1 376 239 A2**
(43) Date of publication of application: **02.01.2004**
(21) Application number: 03014286.3
(22) Date of filing: 25.06.2003
(51) Int. Cl.: G03F 7/20, G02B 7/00

(54) **Cooling device for an optical element**

(30) Priority: 25.06.2002 JP 2002184512; 03.07.2002 JP 2002194613; 04.07.2002 JP 2002195766; 04.04.2003 JP 2003101439
(71) Applicant: Nikon Corporation, Tokyo (JP)
(72) Inventor: Oshino, Tetsuya, Tokyo 100-8331 (JP); Ota, Kazuya, Tokyo 100-8331 (JP); Kondo, Hiroyuki, Tokyo 100-8331 (JP); Tanaka, Keiichi, Tokyo 100-8331 (JP)
(74) Representative: Viering, Jentschura & Partner

(57) **Abstract**

Devices are disclosed that cool optical elements with which the devices are associated, most advantageously reflective optical elements such as mirrors and reflective reticles. The devices have especial utility for reducing deformation and other undesired thermal changes of the respective optical elements, such as optical elements used in extremely demanding optical systems such as used in microlithography systems, most notably EUVL systems. Many of the subject devices typically include a heat-receiving plate or analogous feature that receives heat radiated from the optical element across a gap between the optical element and the heat-receiving plate. Some devices include a plate-cooling device for removing heat from the heat-receiving plate. Other devices employ conduction of heat away from the optical element. Yet other devices employ a flowing heat-transfer medium for removing heat from the optical element. Certain devices also are configured to provide mechanical support for the respective optical elements, notably in a manner that limits deformation of the optical elements.

## Description

### Field

This disclosure pertains to devices and methods for cooling an optical element, such as a lens, mirror, mask, or reticle, especially as used in a microlithographic-exposure apparatus in which the optical behavior of the optical element could be changed unacceptably by a thermal change. The devices and methods are especially suitable for cooling an optical element so as to reduce thermal deformation of the element and accompanying degradation of optical performance, especially of the element as used in high-precision optical systems such as microlithography systems. The devices and methods can be used in a vacuum environment such as required for extreme ultraviolet lithography (EUVL) systems. The subject devices can be integrated with devices used for supporting the optical elements.

### Background

In recent years, as the sizes of active circuit elements in semiconductor integrated circuits, displays, and the like have become progressively smaller, the need has become acute for "next generation" microlithography methods that are capable of achieving finer image resolution than currently obtainable using "optical" microlithography (*e.g.*, microlithography performed using ultraviolet light). The resolution currently obtainable using optical microlithography (as well as any other lithographic technology using electromagnetic radiation) is limited by diffraction. But, in general, the shorter the wavelength of the radiation, the potentially finer the achievable resolution. Hence, to obtain finer resolution than obtainable using optical microlithography, much research and development has been expended on approaches that use shorter wavelengths.

Current "next generation lithography" (NGL) technology relies upon use of wavelengths of exposure light that are largely in the "soft" x-ray, extreme ultraviolet (EUV), and x-ray wavelengths. For example, substantial effort has been expended in the development of extreme ultraviolet lithography (EUVL), which uses wavelengths in the range of 5 to 20 nm. Most work to date has been performed at EUV wavelengths of 11 to 13 nm.

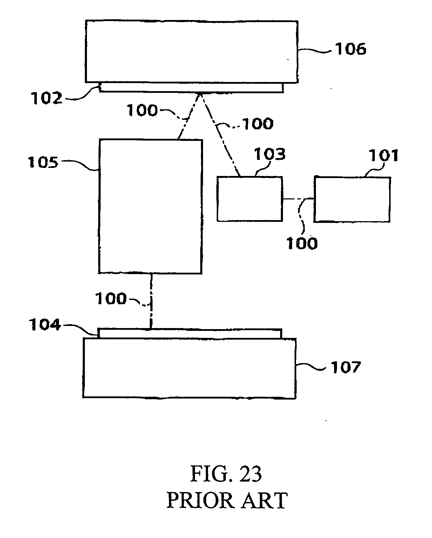

A contemporary EUVL system is shown schematically in FIG. 23, in which the subject system includes an EUV source 101 and an illumination-optical system 103 that directs EUV light 100 (λ = 13.4 nm) emitted from the EUV source 101 to a reflective reticle 102. The reticle 102 defines features of a pattern to be transferred from the reticle to a lithographic substrate 104. Light reflected from the reticle 102 carries an aerial image of the pattern defined on the reticle and is projected by a projection-optical system 105 onto the substrate 104 (usually a resist-coated semiconductor wafer). The reticle 102 is mounted on a reticle stage 106, and the substrate 104 is mounted on a substrate stage 107. As the beam from the projection-optical system 105 is incident on the substrate 104, an actual image of the illuminated portion of the reticle 102 is formed and imprinted on the substrate 104.

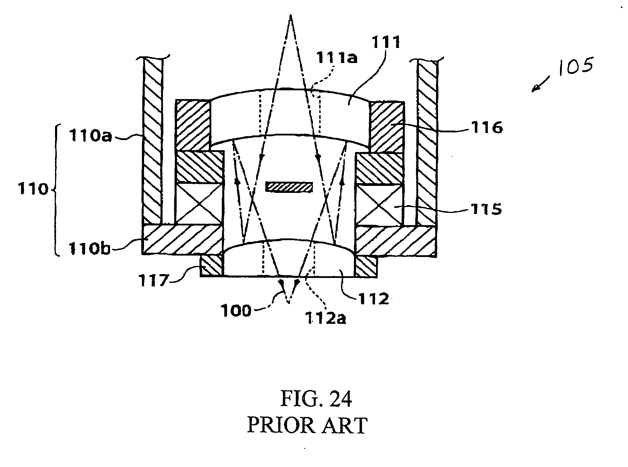

Essentially all known substances absorb the wavelength of EUV light 100 emitted from the EUV source 101. Consequently, an EUV optical system, unlike the refractive optical system used in an optical microlithography system, uses a reflective optical system that comprises multiple reflective mirrors. In one example of a conventional EUVL system, the projection-optical system 105 includes six multilayer-coated EUV-reflective mirrors (not detailed) that collectively project the aerial image at a "reduction" (demagnification) ratio of 1/4 or 1/5, for example. For making exposures, the projection-optical system 105 typically has an optical field that is a portion of an annulus. Such an optical field has exemplary dimensions of 2 mm in width and 30 mm in length on the substrate 104. The respective reflective surface of each of the mirrors of the projection-optical system 105 typically is aspherical, and includes, for exhibiting high reflectivity to EUV light of λ = 13.4 nm, a Mo/Si multilayer coating. Since the optical field is too small to expose an entire pattern in one exposure shot, the pattern is exposed portion-by-portion, accompanied by corresponding scanning motions of the reticle 102 and substrate 104, as performed by their respective stages 106, 107. The scanning velocity of the substrate 104 relative to the scanning velocity of the reticle 102 reflects the demagnification ratio of the projection-optical system 105. Such scanning exposure achieves transfer of a pattern that is substantially larger than the optical field of the projection-optical system 105. An exemplary EUV-optical system 105 comprising two multilayer-coated reflective mirrors 111, 112 is shown in FIG. 24, in which the mirrors are mounted in an optical "column" 110. The column 110 includes a main portion 110a and a flange portion 110b, both desirably made of invar or a related material that exhibits very low thermal deformation.

The mirror 111 is supported in the column 110 by a respective holding device 116, with a position-adjustment mechanism 115 (*e.g.*, piezo-electric actuator or the like) situated between the holding device 116 and the flange portion 110b. The position-adjustment mechanism 115 is used for adjusting the position of the mirror 111 during assembly or later, *e.g.,* during use of the EUV-optical system 105. The mirror 112 is supported by a respective holding device 117 "below" the flange portion 110b Each mirror defines a respective void 111a, 112a. EUV light 100 propagating from upstream (entering the top of the figure from the source or from the reticle) reaches the "upper" surface of the mirror 112 via the void 111a defined in the mirror 111. The EUV light 100 propagates to the "lower" surface of the mirror 111, from which the light is reflected "downward" through the void 112 to the reticle or substrate (not shown).

In the EUV optical system of FIG. 24, each reflective surface of the mirrors 111, 112 has a Mo/Si multilayer coating on the respective surface. The multilayer coatings render the respective mirrors highly reflective to a particular wavelength of EUV light. Unfortunately, whereas a reflectivity of or close to 100 % is desired, such high reflectivity has not been achieved even from multilayer-coated mirrors. For example, if the EUV light 100 has a wavelength of 13 nm, a reflectivity (to perpendicularly incident EUV light of this wavelength) of approximately 70% is obtained from a multilayer coating that comprises 40 to 50 pairs of alternating Mo and Si layers formed with a period of approximately half the incident wavelength. Hence, whereas 70% of the incident-light energy is reflected, the remaining 30% of incident energy is absorbed in the mirror as heat. The amount of heat absorbed under such conditions ranges from a fraction of a watt to a few watts. Nevertheless, this heat is sufficient to cause unwanted thermal deformation of the reflective surface of the mirror.

A conventional EUV projection-optical system has a numerical aperture of 0.2 to 0.3, for example, and the wavefront aberration of the system should be 1 nm (RMS) or less. To achieve such a small wavefront aberration, the mirrors of an EUV optical system typically have aspherical reflective surfaces that are formed and mounted extremely accurately in the optical column.

EUV light in the wavelength range of 5 to 20 nm is greatly absorbed by gas at room temperature. Consequently, the optical path of an EUV optical system must be at high vacuum in a vacuum chamber. Consequently, the mirrors and other optical elements of the EUV optical system must be situated in the vacuum chamber. As noted above, whenever EUV radiation is incident on a reflective mirror, the illuminated portion of the reflective surface experiences heating due to absorption of some of the energy of incident radiation. In a vacuum environment in which EUV optical systems typically are used, the ability of warmed mirrors to transfer heat away is poor. Consequently, the optical elements (including multilayer-coated mirrors) tend to experience an unacceptable degree of thermal deformation.

To solve this problem, there is a need for devices and methods for limiting such thermal deformation, *e.g.*, by cooling the optical elements. Unfortunately, conventional methods for cooling mirrors and the like rely upon actual contact of a cooling device with the subject optical element, which poses a substantial risk of deforming the elements due simply to the contact (which tends to apply a force to the optical element). As a result, conventionally, there is a substantial risk that the desired highly accurate profile of the reflective surface of such an optical element cannot be maintained.

Also, direct-contact cooling devices tend to conduct excessive vibration directly to the optical elements. The vibration degrades the optical performance of the elements.

One conventional approach to reducing thermal expansion of EUV mirrors is to form the multilayer coatings on mirror-substrate materials that exhibit low thermal expansion. For example, low-expansion glass typically is used, having a linear-expansion coefficient of approximately 10 ppb (*e.g.*, "Zerodur" made by Schott Corporation and "ULE" made by Corning).

Unfortunately, use of these low-expansion materials does not completely prevent excessive thermal expansion of the mirrors. To achieve a desired image-formation performance in EUVL, the allowable wavefront aberration in the projection-optical system is 1 to 0.5 nm or less. In a projection-optical system comprising six mirrors, the allowable profile error of each mirror is 0.2 to 0.1 nm or less. Most of this tolerance is consumed by mirror processing, assembly errors, and the like. Consequently, the residual latitude allowed for thermal deformation of the mirrors is extremely small. Indeed, the estimated thermal deformation (10 ppb) experienced even when low-expansion glass is used greatly exceeds this tolerance.

Typically, whenever a mirror used in an EUV optical system experiences heating, the heating begins on the "front" (reflective) surface of the mirror and propagates by thermal conduction through the thickness dimension of the mirror to the "rear" surface of the mirror. The thermal conductivity of low-expansion glass is very low compared to metal or the like, which causes a very slow thermal conduction through the mirror and results in a large temperature gradient between the front and rear surfaces of the mirror. For the same reason, lateral propagation of heat in the mirror also is very slow, which causes a non-uniform in-plane temperature distribution of the mirror. Due to these temperature gradients, the thermal expansion of the mirror being surficially heated is anisotropic, which causes deformation of the surface profile of the mirror.

Deformation of the reflective surface of the mirror also can be caused by static deformation due to the mirror having to support its own mass, fluctuations in ambient atmospheric pressure, dynamic vibration propagating upward from the floor to the mirror, reaction forces generated by stage movements, vibrations from transport systems, *etc.*

In any event, adequate removal of heat from mirrors and other optical systems used in optical systems of the general type described above, without contributing to other deformations of the mirrors, would be especially desirable for achieving the optical-performance goals of such systems.

### Summary

According to a first aspect of the invention, optical-element-cooling devices are provided. An embodiment of such a device comprises a heat-receiving plate arranged proximally to a respective optical element along a surface of the optical element at which light directed to the optical element is not incident or outgoing. Desirably, the heat-receiving plate is arranged conformably to at least a portion of the surface of the optical element at which light directed to the optical element is not incident or outgoing. In any event, the heat-receiving plate is configured to receive heat from the optical element. The device also includes a plate-cooling device that removes heat from the heat-receiving plate. The plate-cooling device desirably contacts the heat-receiving plate in a conforming manner.

The optical element can be, for example, a mirror having a reflective surface. With such an optical element, the heat-receiving plate desirably is arranged along at least one surface of the mirror other than the reflective surface of the mirror, for example, along a rear surface of the mirror. Alternatively or in addition, the heat-receiving plate can be arranged along a side surface of the mirror.

Desirably, the heat-receiving plate does not contact the optical element. Nevertheless, by absorbing heat radiating from the optical element, the heat-receiving plate maintains the optical element at a desired temperature. This temperature maintenance is especially enhanced by cooling the heat-receiving plate. Thus, thermal deformation of the optical element is prevented while also preventing deformation of the optical element that otherwise could be caused by transfer of mechanical stresses to the optical element from the heat-receiving plate.

The heat-receiving plate desirably is made of a material selected from a group consisting of metals and ceramics, and the plate-cooling device desirably comprises at least one heat pipe affixed to a surface of the heat-receiving plate facing the optical element. This configuration further can include a liquid-cooled body to which the at least one heat pipe is connected. The liquid-cooled body removes heat conducted thereto by the at least one heat pipe from the heat-receiving plate.

A surface of the heat-receiving plate facing the optical element desirably is processed so as to increase a heat-absorption efficiency of the surface compared to an otherwise similar non-processed surface. For example, the surface can be processed to provide a ceramic, oxide-, carbide-, or nitride-containing coating on the surface. As another example, the surface can be processed to provide an increased surficial roughness or surficial irregularity resulting in an increased heat-absorption area of the surface. The surface can be processed in a spatially distributed manner to provide the increased heat-absorption efficiency to pre-determined locations on the surface.

In addition or alternatively, a surface of the optical element facing the heat-receiving plate can be processed so as to increase a heat-radiation efficiency of the surface compared to an otherwise similar non-processed surface. For example, the surface can be processed to provide an increased surficial roughness or surficial irregularity resulting in an increased heat-radiation area of the surface. The surface can be processed in a spatially distributed manner to provide the increased heat-radiation efficiency to pre-determined locations on the surface.

The optical-element-cooling device further can comprise a heat-proofing device situated relative to the heat-receiving plate and plate-cooling device so as to block thermal radiation selected from: (a) from the heat-receiving plate to another optical element, and (b) from another optical element to the optical element being cooled by the heat-receiving plate. The heat-proofing device desirably comprises a second heat-receiving plate and an associated heating device that collectively offset heat-sink effects of the heat-receiving plate and plate-cooling device on a neighboring heat-sensitive component. Further desirably, the plate-cooling device conforms to the heat-receiving plate, and the heat-proofing device conforms to the first heat-receiving plate.

As noted above, the heat-receiving plate desirably is separated from the optical element by a gap. Alternatively, the heat-receiving plate can be in actual contact with the surface of the optical element so as to conduct heat from the surface. If a gap is provided, however, the gap can be constant or variable. A variable gap provides pre-determined respective greater or lesser heat-transfer rates from selected corresponding locations on the surface of the optical element.

According to another aspect of the invention, methods are provided for cooling an optical element. In an embodiment of such a method, a heat-receiving plate is situated in proximity to an optical element along a surface of the optical element at which light is not incident to or outgoing from the optical element. Thus, the heat-receiving plate receives and absorbs heat from the optical element. The heat-receiving plate is cooled to remove absorbed heat from the heat-receiving plate. The heat-receiving plate desirably is situated so as to absorb heat radiated from the optical element.

Cooling the heat-receiving plate desirably is performed by conducting heat from the heat-receiving plate using at least one heat pipe coupled to a liquid-cooled body that removes heat from the heat pipe, wherein the heat pipe conducts away heat from the heat-receiving plate.

The method further can comprise the step of blocking radiation of heat from the heat-receiving plate to another optical element. Similarly, the method further can comprise the step of blocking any heat-sink effect, resulting from cooling the heat-receiving plate, of the heat-receiving plate on neighboring components.

The optical element can be cooled during actual use of the element or during periods in which the optical element is not being used.

According to another aspect of the invention, optical systems are provided. An embodiment of an optical system comprises an optical element and an optical-element-cooling device, as summarized above, situated relative to the optical element so as to cool the optical element. Such an optical system can be configured for use in a microlithography system, such as a microlithography system utilizing reflective optics (*e.g.*, an EUVL system). In an EUVL system the subject optical element can be, for example, a mirror or reflective reticle. An EUV-reflective mirror typically has an EUV-reflective multilayer-coated surface. The subject optical systems can be, for example, a projection-optical system as used in an EUVL system.

Another embodiment of an optical-element-cooling device is especially suitable for use in a vacuum environment. This embodiment comprises at least one electronic cooling element (*e.g.*, Peltier element) having a hot side and a cold side. A respective spring member is arranged between the optical element and the cold side of the electronic cooling element. At least one heat pipe is connected to the hot side of each electronic cooling element and configured for transferring heat away from the hot side and thus from each respective electronic cooling element. A heat-pipe-cooling device is connected to the at least one heat pipe and configured for removing heat from each heat pipe. By connecting the electronic cooling element to the optical element using a spring member, optical-element deformations that otherwise could be transmitted to the optical element are blocked by the spring member. The spring member desirably has low rigidity (*e.g.*, a flat spring), desirably is made of a material having high thermal conductivity, desirably exhibits little to no outgassing in a vacuum environment, and desirably has a low coefficient of thermal expansion.

The optical element can be, for example, a reflective optical element having a reflective surface and a non-reflective surface. In this instance multiple spring members desirably are attached to the non-reflective surface and extend from the non-reflective surface to the at least one heat pipe. The non-reflective surface desirably is configured to define multiple voids therein, wherein each void has an associated respective electronic cooling element extending into it. At least one respective spring member is associated with each void so as to connect a portion of the non-reflective surface in the void to a cold side of the respective electronic cooling element. This configuration also desirably includes a controller connected to each of the electronic cooling elements, wherein the controller is configured to operate each of the electronic cooling elements in a controllable manner to provide a respective desired amount of cooling to the respective portion of the non-reflective surface. Reflective optical elements typically absorb a portion of the radiation incident on them, which causes heating of the elements. Since the intensity of incident light is usually not uniform, the distribution of temperature of the element is correspondingly not uniform. By separately controlling operation of the multiple electronic cooling elements, cooling of the optical element can be tailored for the particular thermal distribution of the optical elements. This control of the electronic cooling elements can be facilitated by feedback from temperature sensors strategically placed relative to the optical element.

This embodiment also can include an optical-element-holding device situated and configured to mount the optical element in an optical column. The optical-element-holding device can be configured with multiple holding "cells" that are connected to respective locations on the optical element by a respective spring member. Each holding cell desirably is connected to a heat pipe by a respective spring member. Further desirably, a respective unit of thermally insulative material is situated between each holding cell and its respective spring member connecting the holding cell to the heat pipe.

Another embodiment of an optical-element-cooling device, particularly suitable for use in a vacuum environment, comprises at least one electronic cooling element (*e.g.*, Peltier element) as summarized above, wherein the cold side is adjacent the optical element but separated from the optical element by a gap. The cold side of the electronic cooling element desirably extends into a respective void in the surface of the optical element. A heat-transfer element is situated relative to the hot side of each electronic cooling element and configured to conduct heat away from the hot side. A cooling mechanism is provided for removing heat from the heat-transfer element. The device desirably further comprises a gas-delivery device situated and configured to direct a flow of a gas into the gap, wherein the gas serves to conduct heat from the optical element to the at least one cooling element. The device also desirably includes a gas-evacuation device situated and configured to remove the gas from the gap. By introducing the gas into the gap, thermal transfer from the optical element to the electronic cooling elements is facilitated.

Extending the electronic cooling elements into respective voids allows the gap to be very small, resulting in more efficient radiation of heat from the optical element to the electronic cooling elements. Optical elements configured as mirrors typically are fabricated from glass or other material having a low thermal conductivity, but high precision and stability of the optical element requires that the glass be thick, which works against more efficient thermal transfer. Hence, thinner elements are preferred. The voids help provide adequate rigidity of thinner optical elements. The voids also increase the thermal-radiation area of the optical elements, which increases the efficiency of thermal transfer from the optical elements to the electronic cooling elements. By way of example, the voids can provide a honeycomb profile to the surface of the optical element.

The gap can be configured to define a substantially closed space between the optical element and the electronic cooling element(s), wherein the gas-evacuation device removes gas from the substantially closed space.

The device can include multiple electronic cooling elements situated adjacent respective locations on a surface of the optical element and separated from the respective location by a respective gap. This configuration desirably further includes a controller connected to each of the electronic cooling elements and configured to control independently each of the cooling elements to provide a respective desired amount of cooling to a respective portion of the optical element.

The device further can comprise at least one spring member that connects the cold side of each electronic cooling element to a respective portion of the non-reflective surface in each void. In this configuration the heat-transfer element desirably is a heat pipe, and each spring member desirably is thermally conductive. The spring member(s) prevent transmission of mechanical stresses from the optical element to the electronic cooling element(s) or from the electronic cooling element(s) to the optical element, which providing good thermal transfer from the optical element to the electronic cooling element(s).

This device embodiment further can comprise an optical-element-holding device situated and configured to provide a physical mounting for the optical element in an optical column as the optical-element-cooling device cools the optical element. The optical-element-holding device desirably comprises multiple holding cells connected to the heat-transfer member via a respective spring member, as summarized above. Further desirably, a respective unit of thermally insulative material is situated between each holding cell and its respective spring member connecting the holding cell to the heat-transfer member. These spring members and insulative material provide desirable isolation from transmission of thermal and physical stresses.

Another embodiment of an optical system is especially suitable for use in a microlithography system. The optical system comprises at least one reflective optical element having a reflective surface that receives incident radiation and reflects at least a portion of the incident radiation. The optical system also includes a respective optical-element-cooling device associated with the optical element. The optical-element-cooling device comprises: (a) at least one electronic cooling element having a hot side and a cold side, wherein each cooling element is situated relative to the optical element such that the cold side is adjacent the optical element but separated from the optical element by a gap, (b) a first heat-transfer element situated relative to the hot side of each electronic cooling element and configured to conduct heat away from the hot side, and (c) a first cooling mechanism for removing heat from the first heat-transfer element. The optical element can be, for example, a mirror or a reflective reticle. The optical system can be configured as an illumination-optical system for directing a flux of light to a reticle or as a projection-optical system for directing a flux of light from the reticle to a lithographic substrate.

The optical system further can comprise a vacuum chamber containing the at least one reflective optical element and associated respective optical-element-cooling device. In this configuration, a second heat-transfer element desirably is arranged so as to extend through a wall of the vacuum chamber. A spring member connects the first heat-transfer element to the second heat-transfer element. The system also includes a second cooling mechanism for cooling the second heat-transfer element. The system further can include a flexible member situated between the second heat-transfer element and the wall of the vacuum chamber. In addition, a unit of thermally insulative material can be situated between the second heat-transfer element and the wall of the vacuum chamber. These various spring members and units of thermally insulative material provide desirable isolation from transmission of thermal and physical stresses.

Yet another embodiment of an optical system comprises a vacuum chamber and multiple reflective optical elements situated relative to each other inside the vacuum chamber. Each optical element has a respective reflective surface that receives incident radiation and reflects at least a portion of the incident radiation. A respective optical-element-cooling device is associated with at least one of the optical elements. The optical-element-cooling device comprises: (a) a cooling element situated inside the vacuum chamber and configured to remove heat from the respective optical element, (b) a first heat-transfer element situated inside the vacuum chamber and configured to remove heat from the cooling element, (c) a second heat-transfer element situated inside the vacuum chamber, (d) a third heat-transfer element situated outside the vacuum chamber, (e) a first thermally conductive spring member connecting the first heat-transfer element to the second heat-transfer element so as to provide a heat-conduction pathway from the first heat-transfer element to the second heat-transfer element, and (f) a second thermally conductive spring member connecting the second heat-transfer element to the third heat-transfer element so as to provide a heat-conduction pathway from the second heat-transfer element to the third heat-transfer element.

The second spring member desirably comprises a respective pair of spring-shaped members conjoined at the wall of the vacuum chamber.

According to another aspect of the invention, EUVL systems are provided. An embodiment of such a system comprises an illumination-optical system that guides EUV light to a reflective reticle, and a projection-optical system that guides EUV light from the reflective reticle to a lithographic substrate while transferring an image of a pattern, defined on the reticle, to the substrate. At least one of the illumination-optical system and projection-optical system comprises a mirror. The system also includes a mirror-cooling device for cooling the mirror. The mirror-cooling device comprises a delivery device situated and configured to deliver a cooling medium (*e.g.*, gas or liquid) to at least one of the reflective surface, rear surface, and side surface of the mirror. The delivery device can comprise a nozzle or the like connected to a supply of the cooling medium. The delivered cooling medium contacts the mirror and cools the mirror by thermal conduction and heat of vaporization.

The system desirably further comprises a controller configured to control a timing by which the mirror is cooled using the mirror-cooling device. The controller desirably causes the cooling medium to be delivered whenever the lithographic-exposure system is not being used for making a lithographic exposure.

The system further can comprise a cooling-medium-evacuation device situated and configured to recover cooling medium delivered by the delivery device.

Another embodiment of a lithographic-exposure system comprises an illumination-optical system that guides EUV light from a source to a reflective surface of a pattern-defining reflective reticle. A projection-optical system guides EUV light from the reflective surface to a lithographic substrate, thereby transferring the pattern to the substrate. The system includes a reticle-cooling device for cooling the reflective reticle. The reticle-cooling device comprises a delivery device situated relative to the reticle and configured to deliver a cooling medium so as to pass over the reflective surface of the reflective reticle. The system desirably further comprises a controller configured to control cooling of the reflective reticle by the reticle-cooling device, in which controlled cooling the delivery device is situated at a position that will not block EUV light incident on the reflective surface of the reticle, at which position the cooling medium is delivered by the delivery device.

The system further can comprise an evacuation device situated relative to the reticle and delivery device and configured so as to evacuate the cooling medium delivered by the delivery device.

The cooling medium can be a gas or a liquid that cools the reticle by thermal conduction and heat of vaporization. Exemplary gases are helium and nitrogen. Exemplary liquids are liquid nitrogen, liquid helium, and ethanol.

Another method embodiment is directed to cooling an EUV-reflective mirror having a front surface and a rear surface. The method comprises delivering a cooling medium into contact with at least one of the front surface or the rear surface of the mirror. The method desirably further includes the step of evacuating the cooling medium after the cooling medium has contacted the surface.

Yet another method embodiment is directed to cooling a reflective reticle having a reflective surface that defines a pattern to be transferred to a lithographic substrate by a beam of EUV light. The method comprises delivering a cooling medium at the reticle so as to cause the cooling medium to contact the reflective surface of the reticle. The method further can comprise the step of evacuating the cooling medium after the cooling medium has contacted the reflective surface.

Another reticle-cooling embodiment is set forth in the context of a microlithography method in which a pattern, defined on a reflective reticle, is transferred to a lithographic substrate by guiding a beam of EUV light through an illumination-optical system to the reflective reticle. A beam of EUV light also is guided through a projection-optical system from the reticle to the substrate. In the reticle-cooling method a delivery device is placed relative to the reticle so as not to block EUV light incident on or reflected from the reticle. While lithographic exposure is being performed using the reticle, the reticle is cooled by releasing a cooling medium from the delivery device at a surface of the reticle.

Yet another embodiment of an optical-element-cooling device is a device that cools the optical element as the optical element is being supported in an optical column. The optical element has an optical-function surface, a non-optical-function surface, and a peripheral-side surface. The device comprises multiple (desirably at least three) optical-element-support members mounted to respective locations (desirably equi-angularly distributed) on a surface (desirably a peripheral surface) of the optical element other than the optical-function surface. The device also comprises a cooling frame to which the optical-element-support members are attached so as to support the optical element relative to the cooling frame. The device also comprises a heat-conductive plate disposed along the non-optical-function surface of the optical element. The heat-conductive plate has a periphery that is connected to the cooling frame in a manner allowing the cooling frame to remove heat from the heat-conductive plate. The cooling frame defines a conduit through which a cooling medium is conducted so as to remove heat from the cooling frame and hence from the heat-conductive plate as the optical element is being supported by the cooling frame.

Each optical-element-support member desirably is made of a material having a low coefficient of thermal expansion and that is flexibly deformable in directions that are normal to the respective location on the peripheral-side surface. The optical-element-support members desirably are attached to respective locations on the peripheral-side surface.

The heat-conductive plate desirably is separated from the non-optical-function surface by a defined gap that can be constant or variable.

The heat-conductive plate desirably conforms to the shape of the non-optical-function surface, and can be configured to have a convex inverted-bowl shape extending toward the non-optical-function surface.

The gap can have a respective dimension at each of multiple locations so as to achieve a respective desired individual rate of thermal transfer at each location from the non-optical-function surface to the heat-conductive plate. The individual rates desirably are sufficient to achieve a substantially uniform distribution of temperature at the optical-function surface of the optical element. The individual rates can be sufficient to achieve a pre-determined distribution of temperature at the optical-function surface of the optical element.

Each optical-element-support member can comprise a linking member including a pair of flat springs providing the flexible deformability of the optical-support member.

The device can further comprises a base and multiple cooling-frame-support members affixed to the base and extending between the base and respective locations on the cooling frame so as to support the cooling frame relative to the base. For example, the cooling-frame-support members can be configured to support the cooling frame peripherally relative to the base. Each cooling-frame-support member can comprise at least one respective flat spring that is flexibly deformable in a respective direction that is normal to the respective location on the cooling frame. Each cooling-frame-support member further can comprise: (a) a respective cooling-frame actuator that is movable, when energized, in a direction parallel to an optical axis of the optical element, thereby moving the cooling frame in the direction relative to the base, and (b) a first sensor situated and configured to detect a distance between the base and the non-optical-function surface of the optical element. The first sensor can comprise a laser interferometer that directs a beam of laser light through the heat-conductive plate to the optical element. The first sensor is especially suitable for providing feedback positional data to the respective cooling-frame actuator.

The base typically is mounted to the optical column. In such a configuration, the device further can comprise: (a) at least one base actuator that is movable in at least one orthogonal direction perpendicular to the optical axis of the optical element, thereby moving the base and cooling frame in the orthogonal direction relative to the optical column, and (b) a second sensor situated and configured to detect a displacement of the base relative to the optical column. The second sensor can be configured to provide feedback position data to the respective base actuator.

Another embodiment of an optical system, configured for use in a microlithography system, comprises an optical column, a reflective optical element having an optical-function surface that receives radiation and reflects at least a portion of the incident radiation, and an optical-element-cooling device as summarized above. The optical-element-cooling device is especially suitable for cooling the optical element as the optical element is being supported in the optical column. The system further can comprises a vacuum chamber enclosing the optical column.

Another embodiment of a method for cooling an EUV-reflective optical element, as the optical element is being supported in an optical column, comprises the step of attaching the optical element to a cooling frame by multiple optical-element support members extending from the cooling frame to respective locations on the non-optical-function surface. The cooling frame defines a fluid conduit. A heat-conductive member, connected to the cooling frame, is placed relative to the non-optical-function surface and separated from the non-optical-function surface by a gap so as to allow the heat-conductive member to absorb heat radiating across the gap from the optical element. A cooling fluid is circulated through the fluid conduit while conducting heat from the heat-conductive member to the cooling frame, thereby transferring heat from the heat-conductive member to the cooling frame and to the cooling fluid.

The method further can comprise mounting the cooling frame to a base that is connected to the optical column, detecting a position of the cooling frame (and hence of the optical element) relative to the base, and, based on the detected position of the cooling frame, adjusting the position of the cooling frame relative to the base. The method further can comprise the steps of detecting a position of the base relative to the optical column, and, based on the detected position of the base, adjusting the position of the base relative to the optical column.

The foregoing and additional features and advantages of the invention will be more readily apparent from the following detailed description, which proceeds with reference to the accompanying drawings.

### Brief Description of the Drawings

FIG. 1 is a schematic diagram showing certain general features of an extreme ultraviolet lithography (EUVL) system that can be provided with at least one cooled optical element.
FIG. 2 is a schematic diagram showing certain general features of another EUVL system that can include at least one cooled optical element.
FIG. 3 is a side elevational view schematically depicting a mirror (as an exemplary optical element) and optical-element-cooling device according to the first representative embodiment.
FIG. 4 is a plan view of the embodiment of FIG. 3, detailing the arrangement of heat pipes that conduct heat away from the mirror.
FIGS. 5(A)-5(B) are oblique elevational views of two respective configurations of protrusions formed on the first heat-receiving plate of the embodiment of FIG. 3, wherein the protrusions facilitate radiative thermal transfer from the mirror to the first heat-receiving plate.
FIG. 5(C) is a plan view showing a thermal-transfer-enhancing coating applied to a selected region on the surface of the first heat-receiving plate of the embodiment of FIG. 3.
FIG. 6(A) is a side elevational view schematically showing a mirror having a convex rear surface and conforming first heat-receiving plate situated adjacent the rear surface without contacting the rear surface, as described in the first representative embodiment.
FIG. 6(B) is a side elevational view showing detail of interdigitated protrusions on the rear surface of a mirror and on the conforming surface of the first heat-receiving plate, as described in the first representative embodiment, for enhancing radiative thermal transfer from the mirror to the first heat-receiving plate.
FIG. 7 is a schematic diagram of a projection-optical system of an exemplary EUVL system that includes one or more multiple optical-element-cooling devices, according to the second representative embodiment.
FIG. 8 is a side elevational view schematically depicting a mirror (as an exemplary optical element) and mirror-cooling device, according to the third representative embodiment.
FIG. 9 is a plan view of a portion of the mirror shown in FIG. 8, showing details of the configuration of the mirror-cooling device.
FIG. 10 is a side elevational view schematically depicting a mirror (as an exemplary optical element) and mirror-cooling device, according to the fourth representative embodiment.
FIG. 11 is a side elevational view schematically depicting a mirror (as an exemplary optical element) and mirror-cooling device, according to the fifth representative embodiment.
FIG. 12 is a side elevational view schematically depicting certain features of an EUVL system including multiple optical elements and at least one optical-element-cooling device, according to the sixth representative embodiment.
FIG. 13 is a side elevational view showing certain details of the arrangement of heat pipes and spring members in the embodiment of FIG. 12.
FIG. 14 is a side elevational view of a mirror (as an exemplary optical element) and mirror-cooling device, according to the seventh representative embodiment.
FIG. 15 is a side elevational view of the mirror of FIG. 14 and a modification of the mirror-cooling device shown in FIG. 14.
FIG. 16 is a side elevational view of a mirror (as an exemplary optical element) and mirror-cooling device, according to the eighth representative embodiment.
FIG. 17 is a side elevational view of a mirror (as an exemplary optical element) and mirror-cooling device, according to the ninth representative embodiment.
FIG. 18 is an elevational schematic diagram of an EUVL system including at least one optical-element-cooling device, according to the tenth representative embodiment.
FIGS. 19(A)-19(B) depict an optical-element-cooling device according to the eleventh representative embodiment, wherein FIG. 19(A) is an elevational section, and FIG. 19(B) is a plan view.
FIG. 20 is an elevational section showing certain details of the embodiment shown in FIG. 19(A).
FIG. 21 is an oblique view of the bowl face of the heat-conductive plate of the cooling device shown in FIGS. 19(A)-19(B).
FIG. 22(A) is a plan view of a support member used in the embodiment of FIGS. 19(A)-19(B).
FIG. 22(B) is a plan view of the cooling-frame-support member used in the embodiment of FIGS. 19(A)-19(B).
FIG. 23 is a block diagram of a conventional EUVL system.
FIG. 24 is an elevational section of a portion of an optical column as used in a conventional EUVL system.

### Detailed Description

The invention is described below in the context of multiple representative embodiments, which are not intended to be limiting in any way. Although the embodiments are described in the context of extreme ultraviolet (EUV) microlithography systems, it will be understood that the general principles described herein are applicable with equal facility to other types of optical systems and to optical systems intended for use with wavelengths other than EUV wavelengths.

### General Considerations

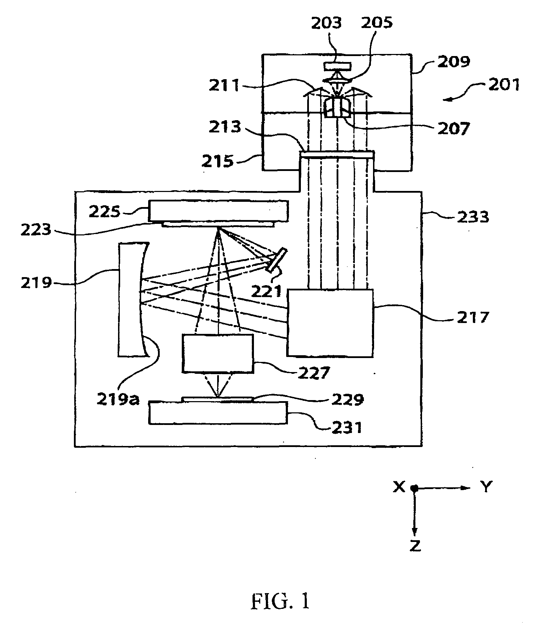

FIG. 1 depicts certain general features of the optical system 201 of an EUV microlithography system, particularly such a system that operates in a step-and-scan manner. The depicted optical system 201 includes a laser-light source 203, which is situated at the extreme upstream end of the system. The laser-light source 203 emits laser light at a wavelength ranging from infrared to visible. For example, the laser-light source 203 can be a YAG laser or excimer laser. Laser light emitted from the laser-light source 203 is converged by a focusing-optical system 205 on a laser-plasma EUV source 207 situated downstream.

The laser-plasma EUV source 207 generates EUV light (λ = 13 nm) with good efficiency in the following manner. A nozzle (not shown) delivers xenon gas to the laser-plasma EUV source 207. The xenon gas released from the nozzle receives pulses of extremely intense laser light from the laser-light source 203, which causes the xenon gas to experience heating to an extremely high temperature sufficient to form a plasma. As the molecules of xenon transition back to a lower energy state, EUV radiation is produced. Since the EUV radiation has low transmission through air, the components 203, 205, 207 are contained inside a vacuum chamber 209 maintained at high vacuum.

Situated just upstream of the laser-plasma light source 207 is a rotating parabolic reflective mirror 211 that has a surficial Mo/Si multilayer coating. EUV radiation radiating from the laser-plasma EUV source 207 is incident to the parabolic mirror 211, and only EUV light having a wavelength in the vicinity of 13 nm is reflected therefrom as a collimated (parallel) beam. The collimated beam propagates downstream to a visible-light cutoff filter 213 that comprises a 0.15-nm thick layer of beryllium. Hence, of the EUV light reflected by the mirror 211, only the desired EUV light passes through and propagates downstream of the cutoff filter 213. The vicinity of the cutoff filter 213 is enclosed by a vacuum chamber 215.

An exposure chamber 233 is situated downstream of the cutoff filter 213, and contains an illumination-optical system 217. The illumination-optical system 217 typically comprises a condenser mirror, a fly-eye mirror, and other mirror(s) as required to form the EUV beam from the cutoff filter 213 into a beam having an arc-shaped transverse section. The EUV beam propagates to the left (in the figure) from the illumination-optical system 217 to an EUV-reflective mirror 219. The mirror 219 is disc-shaped and has a concave reflective surface 219a. EUV light reflected from the mirror 219 is reflected from a mirror 221, which is oriented at an angle relative to the mirror 219. EUV light from the mirror 221 propagates to a reflective reticle 223 (also called a "mask") oriented horizontally "above" the mirror 221 such that the reflective surface of the reticle 223 is oriented "downward" in the figure. Thus, the EUV radiation is incident on a selected region of the reflective surface of the reticle 223.

Each of the mirrors 219, 221 is made from a respective high-precision quartz substrate and has a reflective surface including a Mo/Si multilayer coating. Thus, each of the mirrors 219, 221 exhibits a high (about 70%) reflectivity for EUV light having a wavelength of 13 nm. Note that, for other EUV wavelengths in the range of 10 to 15 nm, the respective multilayer coating can be made of layers of Ru (ruthenium) or Rh (rhodium) alternating with layers of Si, Be (beryllium), or B₄C (carbon tetraboride), to ensure maximal reflectivity to the particular EUV wavelength.

The reflective surface of the reticle 223 also comprises a multilayer coating tailored for the particular wavelength of incident EUV light. On this multilayer coating are formed elements of the pattern defined on the reticle and to be transferred lithographically. The reticle 223 is mounted on a reticle stage 225, which is movable in at least one direction (X or Y direction). EUV light reflected by the mirror 221 is sequentially irradiated onto successive pattern-defining regions on the reticle 223.

Situated downstream of the reticle 223 are a projection-optical system 227 and a lithographic substrate 229. The projection-optical system 227 comprises multiple multilayer-coated mirrors, and is configured such that, as the pattern on the reticle 223 is transferred to the substrate 229, the image of the pattern is "reduced" (demagnified) according to a pre-set demagnification ratio (*e.g.*, 1/4) and resolved onto the surface of the substrate 229. The substrate 229 (*e.g.*, semiconductor wafer) is secured onto the surface of a substrate stage 231 that typically is movable in the X, Y, and Z directions.

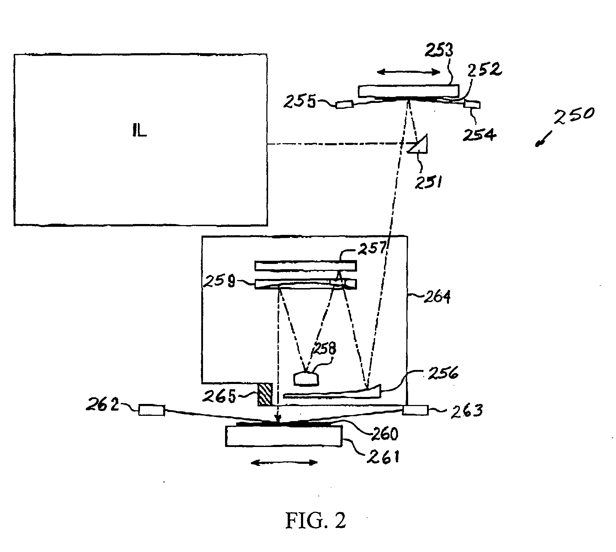

Another configuration of an EUV microlithography system 250 is depicted in FIG. 2, in which the depicted system 250 comprises an illumination system IL including an EUV light source (not detailed). The EUV light source produces a beam of EUV light (in general, λ = 5 to 20 nm, desirably λ = 11 or 13 nm) that is shaped and directed as required by the illumination system IL. The EUV beam from the illumination system IL is directed by a mirror 251 to be incident on a reflective reticle 252. The reticle 252 is mounted on a reticle stage 253, which has a large movement range of 100 mm or more in the scanning direction (Y-axis direction), a smaller movement range in the X-axis direction, and an even smaller movement range in the optical-axis direction (Z-axis direction). Note that movements in the X-axis and Y-axis directions are within a plane denoted as the X-Y plane. The position of the reticle 252 in the X-Y plane is monitored with high precision using a laser interferometer (not shown, but well understood in the art). The position of the reticle 252 in the Z-axis direction is monitored by a reticle-focus sensor including a light-transmission system 254 and a light-receiving system 255.

EUV light reflected by the reticle 252 includes an aerial image of the pattern portion (on the reflective surface of the reticle 252) illuminated by the beam from the illumination system IL. Thus, as described above, the reticle 252 includes a multilayer coating (*e.g.,* Mo/Si or Mo/Be alternating layers) that is reflective to incident EUV light. Pattern features are defined by respective portions and voids in an absorption layer (*e.g.,* Ni or Al) formed on the surface of the multilayer coating. EUV light from the reticle enters an optical column 264 of the projection-optical system. In the optical column 264, the light is reflected by a first mirror 256 and sequentially reflected by a second mirror 257, a third mirror 258, and a fourth mirror 259 so as to be perpendicularly incident on the surface of a lithographic substrate 260 (*e.g.,* semiconductor wafer). Hence, the mirrors 256-259 constitute the projection-optical system, which has a demagnification ratio of, for example, 1/4 or 1/5. Although this configuration includes four mirrors 256-259 in the projection-optical system, six or eight mirrors, for example, alternatively could be used (more mirrors would increase the numerical aperture). The optical column 264 also includes an off-axis microscope (not detailed but well understood in the art) used for aligning the reticle 252 and substrate 260.

For exposure the substrate 260 is mounted on a substrate stage 261. The substrate stage 261 is movable freely within a plane (an X-Y plane) that extends perpendicularly to the optical axis of the projection-optical system. The range of motion of the substrate stage typically is 300-400 mm in each of the X-axis and Y-axis directions. The substrate stage 261 also can be raised or lowered in the Z-axis direction (optical-axis direction). The position of the substrate in the Z-axis direction is monitored by an autofocus detector comprising a light-transmission system 262 and a light-receiving system 263. The position of the substrate in the X-Y plane (defined by the X-axis and Y-axis directions) is monitored with high precision using a laser interferometer (not shown, but well understood in the art). During lithographic exposure the reticle stage 253 and substrate stage 261 are moved in a simultaneously scanning manner at respective velocities according to the demagnification ratio.

### First Representative Embodiment

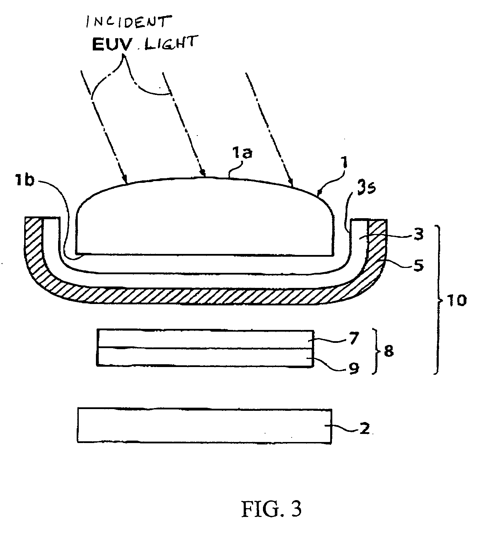

An optical-element-cooling device according to this embodiment is depicted in FIGS. 3, 4, 5(A)-5(C), and 6(A)-6(B). The optical element shown and referred to in this embodiment as a reflective mirror, by way of example, but this is not intended to be limiting in any way.

Turning first to FIG. 3, the depicted mirror includes an aspherical convex reflective surface 1a that includes a Mo/Si multilayer coating for reflecting a prescribed wavelength of incident EUV light (λ = 13.4 nm). The reverse ("rear") surface 1b of the mirror 1 is planar, and represents a surface at which no EUV light is incident and from which substantially no EUV reflects.

A mirror-cooling device 10 is situated adjacent the rear surface 1b of the mirror 1. The mirror-cooling device 10 of this embodiment comprises a first heat-receiving plate 3, a plate-cooling device 5 (comprising a heat pipe 4 and liquid-cooled body 6, the latter being an example of a fluid-cooled body), and a heat-proofing device 8 (heating device 7 and second heat-receiving plate 9). The first heat-receiving plate 3 is adjacent the rear surface 1b and side-circumferential surface (*i.e.,* surfaces other than the reflective surface 1a) of the mirror 1 without contacting the respective surfaces. The first heat-receiving plate 3 is situated and configured so as not to interfere mechanically with either the mirror 1 or the mirror-holding device (not shown). Whenever the mirror 1 has experienced heating from absorption of a portion of the energy of incident EUV light, the heat radiates to the first heat-receiving plate 3.

The first heat-receiving plate 3 is formed from a thin plate made of a suitable metal or ceramic material (an example of the latter is Al₂O₃) that exhibits an appropriately high heat-radiation rate and appropriately high thermal conductivity. The thin-plate configuration of the first heat-receiving plate 3 facilitates forming the plate so as to conform to at least a portion of the rear surface 1b of the mirror 1. This allows the mirror 1 to be made thicker and thus provided with a desirable high rigidity for resistance to mirror-deformation caused by gravity.

Heat transfer (notably heat radiation) from the mirror 1 to the first heat-receiving plate 3 is enhanced by certain processing performed on the mirror-facing surface 3s (or a portion of the surface) of the first heat-receiving plate 3. Exemplary processing in this regard includes forming on the surface 3s a coating of a ceramic or metal-oxide (*e.g.,* copper oxide, aluminum oxide, nickel oxide, *etc.*), of a carbide (*e.g.,* silicon carbide, molybdenum carbide, *etc.*), or of a nitride (*e.g.,* silicon nitride, tantalum nitride, *etc.*). These coatings can be produced by sputtering or other suitable technique.
Alternatively, a suitable coating can be formed by oxidation or other chemical treatment of the base material of the first heat-receiving plate 3. Another alternative processing involves forming a chemical membrane on the surface 3s.

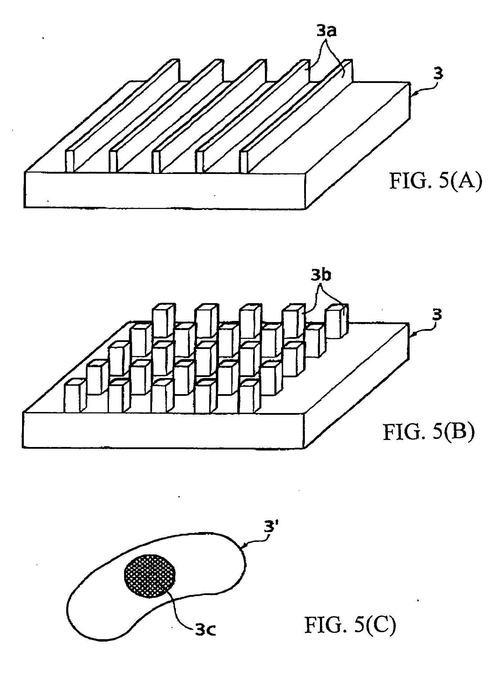

Yet another alternative processing involves increasing the "roughness" of the surface 3s so as to increase the heat-absorption area of the surface 3s. For example, the surface 3s can be provided with multiple fin-shaped protrusions 3a such as shown in FIG. 5(A) or multiple pin-shaped protrusions 3b such as shown in FIG. 5(B). These protrusions can be configured to interdigitate with other protrusions provided on the rear surface 1b of the mirror 1, as discussed later below.

The flux of EUV light incident to the mirror 1 is not necessarily uniform. In many instances, the intensity of EUV light incident to the mirror 1 at a first region on the reflective surface 1a is greater than the intensity at another region on the surface 1a. The more intensely irradiated region will exhibit more heating (and thus a greater temperature increase) than the less intensely irradiated region. In response to this phenomenon, certain corresponding regions of the surface 3s of the first heat-receiving plate 3 can be processed (compared to other regions being not processed) or more extensively processed to increase heat absorption from correspondingly more intensely irradiated regions of the mirror. In other words, the result of processing of the first heat-receiving plate 3 can have a spatial distribution tailored to the degree of local heating of the mirror 1 at various locations on the reflective surface 1a. For example, as shown in FIG. 5(C), increased surface roughness can be provided to the region 3c of the surface 3s, wherein the region 3c corresponds to a region of the mirror that receives more intense radiation than other regions. Thus, cooling of the mirror 1 is tailored to the distribution of local heating of the mirror during use.

As an alternative or in addition to performing processing on the surface of the first heat-receiving plate, the rear surface 16 of the mirror 1 can be processed to increase its efficiency of thermal radiation to the first heat-receiving plate 3, as discussed later below.

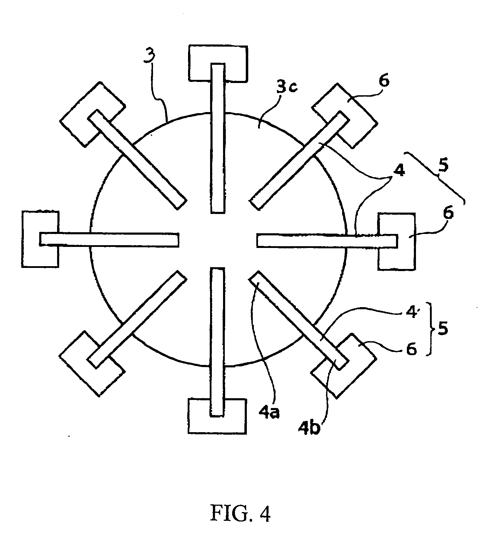

An exemplary configuration of the plate-cooling device 5 attached to the first heat-receiving plate 3 is shown in FIG. 4, which depicts heat pipes 4 affixed to the mirror-facing surface 3c of the first heat-receiving plate 3. The respective distal termini 4b of the heat pipes 4 are connected to a liquid-cooled (*e.g.,* water-cooled) body 6 or analogous heat sink. In the example shown in FIG. 4, the plate-cooling device 5 comprises eight individual heat pipes 4 attached to the surface 3s of the first heat-receiving plate 3. The respective proximal ends 4a of the heat pipes 4 are secured at the center of the surface 3c, and the distal termini 4b extend equi-angularly in a radial manner. The distal ends 4b are attached to the liquid-cooled body 6. Each heat pipe 4 can be configured as having a cross-sectional diameter (or width) of several mm or less so as to conserve space. Heat pipes 4 are usable in a vacuum environment and facilitate efficient thermal transfer from the heat-receiving plate 3. *I.e.*, heat from the mirror 1 is absorbed by the first heat-receiving plate 3, and the resulting heat in the corresponding region of the first heat-receiving plate 3 is absorbed by the respective proximal end(s) 4a of the heat pipes 4. Heat thus absorbed into the heat pipes 4 is conducted rapidly to the respective distal ends 4b, from which heat is removed by the liquid-cooled body 6.

In FIG. 3 the first heat-receiving plate 3 is shaped conformably to the rear surface 1b and the side-circumferential surface of the mirror 1. Alternatively, the first heat-receiving plate 3 can have a shape that simply conforms to the rear surface 1b, such as a simple planar circular configuration (*e.g.,* disc-shaped) or other suitable configuration (*e.g.,* semicircular). In these alternative configurations, the heat pipes 4 can be concentrated at locations subjected to greater heating and generally connected at respective locations to facilitate attainment of the desired temperature regulation at the respective locations. Further alternatively, the first heat-receiving plate 3 may be segmented into multiple plate segments situated adjacent respective regions of the surface 1b requiring cooling, with one or more respective heat pipes 4 connected to each plate segment.

The heat-proofing device 8, as noted above, comprises a heating device 7 and second heat-receiving plate 9. The heat-proofing device 8 is situated outboard of the first heat-receiving plate 3 and plate-cooling device 5, and serves to reduce a possible thermal influence of the first heat-receiving plate 3 and plate-cooling device 5 on the wafer 2 (or reticle or other heat-sensitive component). The heating device 7 can be configured structurally and/or operationally similarly to the heat pipe 4 discussed above. The heating device 7 blocks (offsets) heat radiated outward from the first heat-receiving plate 3 and blocks heat-sink effects of the plate-cooling device 5 on other nearby optical elements (not shown). The second heat-receiving plate 9 desirably has a plate-like configuration and is situated adjacent the side of the heating device 7 facing away from the cooling device 5. The second heat-receiving plate 9 makes uniform the heat produced by the heating device 7 over the heat-proofing device 8.

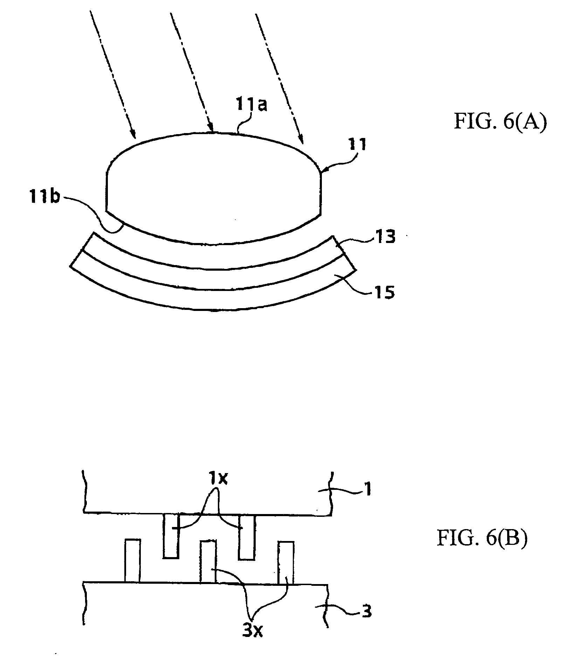

Any one or more of the following increases the efficiency of thermal transfer from the mirror 1 to the mirror-cooling device 10: (1) increasing surface roughness or irregularity, either globally or locally, of the rear surface 1b of the mirror or providing a ceramic or other high-thermal-transfer coating to the surface 1b either locally or globally; (2) as shown in FIG. 6(A), forming the rear surface 11b of the mirror 11 as a curved surface, such as a convex spherical surface, rather than planar, thereby increasing the surface area of the surface 11b (accompanied by arranging the first heat-receiving plate 13 and plate-cooling device 15 in proximate conformity to the surface 11b); and (3) as shown in FIG. 6(B), forming respective protrusions 1X, 3X on the rear surface 1b of the mirror 1 and on the mirror-facing surface of the first heat-receiving plate 3, respectively, wherein the protrusions 1X, 3X are arranged so as to interdigitate with each other. Note that, despite the conformance of the first heat-receiving plate 3 with the rear surface 1b, the respective protrusions 1X, 3X do not contact each other. The protrusions 1X, 3X substantially increase the opposing surface areas of the surface 1b and first heat-receiving plate 3. Combining (2) and (3) is especially effective in achieving good thermal transfer.

Since the first heat-receiving plate 3, 13 is cooled by the respective plate-cooling device 5, 15, the first heat-receiving plate 3, 13 is maintained at a desired temperature. Thus, thermal deformation of the mirror 1,11 is effectively prevented.

### Second Representative Embodiment

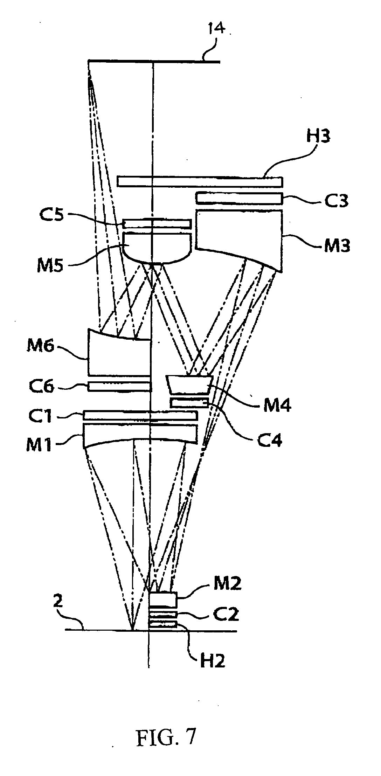

This embodiment is directed to a projection-optical system, of an EUVL system, that includes an optical-element-cooling device as described, for example, in the first representative embodiment. The subject projection-optical system is shown in FIG. 7 in association with a reflective-type reticle 14 (located upstream of the projection-optical system) and a substrate 2 (*e.g.,* semiconductor wafer) located downstream of the projection-optical system. The depicted projection-optical system comprises six EUV-reflective mirrors M1-M6 each including a respective mirror-cooling device C1-C6 arranged in proximity thereto. The projection-optical system also includes two "heaters" H2, H3 associated with the mirror-cooling devices C2, C3, respectively.

Each of the mirror-cooling devices C1-C6 includes a respective heat-receiving plate with attached respective plate-cooling device (not detailed, but see first representative embodiment, *e.g.,* heat-receiving plates 3, heat pipes 4, and liquid-cooled jackets 6). In this example, each of the first heat-receiving plates is a copper plate having a thickness of 2 mm. The surface of each copper plate facing the respective mirror has a copper thermal oxide film (exemplary of processing for increasing the efficiency with which the copper plate absorbs heat from the respective mirror). Connected to each copper plate are multiple respective heat pipes each having an exemplary diameter of 2 mm. The gap between the rear surface of each mirror M1-M6 and the respective first heat-receiving plate is, for example, 0.5 mm. Desirably, each gap is 3 mm or less, but such a gap need not be uniform from every location on the rear surface (it is sufficient if the closest distance in the gap is 3 mm or less). Each of the first heat-receiving plates C1-C6 has a shape that generally conforms to the shape of the respective mirror M1-M6 so as essentially to "cover" the rear surfaces of the respective mirrors.

Each of the heaters H2, H3 is configured substantially as a respective heat-proofing device 8 (comprising a respective heating device 7 and second heat-receiving plate 9), as discussed in the first representative embodiment.

By way of example, the mirror-cooling devices C1-C6 of the projection-optical system shown in FIG. 7 are set to maintain the following average temperatures:
Cooling device C1: 18.6 °C
Cooling device C2: 0.4 °C
Cooling device C3: 6.7 °C
Cooling device C4: 0.9 °C
Cooling device C5: -5.0 °C
Cooling device C6: 14.6 °C
Based on experiments, maintaining the cooling devices C1-C6 at the respective temperatures noted above allows the average temperature of each of the respective mirrors M1-M6 to be maintained at 20 °C.

In FIG. 7, because the area of the rear surface of the second mirror M5 from the reticle 14 is relatively small, the temperature of this mirror M5 is set notably low. The size of the mirror M5 is approximately ten times the actual effective area of the mirror so as to allow the area of the first heat-receiving plate of the respective cooling device C5 to be correspondingly larger. The cooling device C5 is set to approximately -5 °C, which is a temperature that is easy to achieve, to cool the mirror M5 appropriately.

Thus, cooling of the mirrors M1-M6 is performed in a manner that prevents undesirable temperature increases of the mirrors and hence reduces thermal deformation and positional changes of the mirrors during use. The projection-optical system is able to operate without significant deterioration in optical performance (*e.g.*, wavefront aberration) of the constituent mirrors.

### Third Representative Embodiment

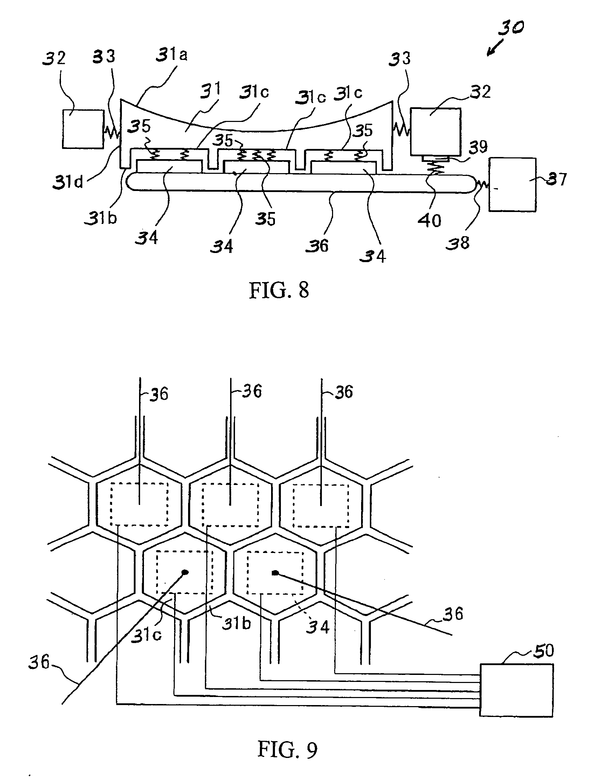

An optical-element-cooling device 30 according to this embodiment is shown in FIGS. 8 and 9. FIG. 8 depicts a single optical element 31 exemplified by a mirror. The mirror 31 has a reflective surface 3 1a that is aspherically concave, and includes a multilayer coating for reflecting incident EUV light. The mirror 31 can be used, for example, in a projection-optical system of an EUVL system. The mirror 31 also has a rear surface 31b in which multiple voids 31c are defined. Each void 31c has a hexagonal shape in this embodiment (see FIG. 9); the resulting "honeycomb" structure provides substantial rigidity to the mirror 31. The mirror 31 also has a side surface 31d that is secured by means of "cells" 32 (respective mirror-holding devices) via spring members 33. Each of the cells 32 is secured to an optical column (not shown). In FIG. 8 the voids 31 c are defined only on the rear surface 31 b of the mirror 31, but it will be understood that voids 1c also or alternatively can be defined on the side surface 31d wherever a cell 32 is not attached.

The optical-element-cooling device 30 also includes multiple electronic cooling elements 34 (desirably Peltier elements, which is the term used generally herein) positioned relative to correspond to respective voids 31c. As shown in FIG. 9, each Peltier element 34 is independently electrically connected to a controller 50. Note that the Peltier elements 34 can be arranged not only adjacent the mirror rear surface 31b but also or alternatively adjacent the side surface 31d and front surface 31a If the Peltier elements 34 are arranged adjacent the front surface 31a they desirably are positioned so as not to block incident or reflected light flux. Respective heat pipes 36 are connected to the respective "hot" sides of one or more Peltier elements 34. Various individual heat pipes 36 are brought together into a trunk heat pipe through which heat is conducted to a cooling device 37. For example, multiple individual heat pipes 36 may be brought together by joining them to a circular trunk heat pipe (not shown) via respective spring members.

In the voids 31c, the "cold" sides of respective Peltier elements 34 are connected dynamically to the mirror 31 via one or more respective spring members 35 each configured with one or more flat and/or coil springs, for example. Each spring member 35 is made of a material exhibiting a low coefficient of thermal expansion, high thermal conductivity, and low outgassing in a vacuum environment. An exemplary material in this regard is "super invar." Each spring member 35 also desirably has low rigidity so as to prevent force from being transmitted through them from the Peltier elements 34 to the mirror 31, which prevents the mirror from being deformed during assembly of the mirror into the optical column or during actual use.

As noted above, the "hot" sides of the Peltier elements 34 are secured to the heat pipes 36. The heat pipes 36 also desirably are connected to the cells 32, by respective units of a thermally insulating material 39 and by respective spring members 40 such as flat springs. The insulating material 39 desirably has low thermal conductivity. An exemplary thermal conductivity is 100 J·m⁻²·K⁻¹ or less, which provides good insulating performance. In addition, the insulating material 39 desirably does not adversely affect obtaining or maintaining a desired vacuum level in which the optical system is used.

According to the criteria above, exemplary insulating materials are as follows: A generally desirable material is a metal alloy of Fe and Ni. More desirable is a ternary alloy such as Ni-Cr-Fe or Fe-Ni-Co. Specific examples are a ternary alloy having a composition ratio of 72 % Ni, 15 % Cr, and 6 % Fe (Inconel 600) or a ternary alloy having a composition ratio of 52 % Fe, 29 % Ni, and 17 % Co (Kovar). Other candidate insulating materials are ceramic materials, metal oxides, metal carbides, metal nitrides, or silicon oxides. Exemplary materials in this regard include Al₂O₃, TiC, SiC, ZrC, HfC, TaC, BN, TiN, AlN and SiO₂ (quartz). Exemplary silicon-oxide ceramics include MgO·SiO₂ (steatite), 3Al₂O₃·2SiO₂ (mullite), and ZrO₂·2SiO₂ (zircon).

The insulating material desirably has a coefficient of thermal expansion that is as close as possible to the thermal expansion coefficient of the material of which the optical column is made. For example, if the optical column is made of invar, the insulating material desirably is low-expansion quartz or low-expansion glass.

The insulating material 39 prevents heat from the heat pipes 36 from being transmitted to the cells 32 (thereby preventing thermal deformation of the cells 32). Also, the spring members 40 desirably are configured to prevent deformation and/or vibration of the heat pipes 36 from being transmitted to the cells 32. If the spring members 40 are made of a material having sufficiently low thermal conductivity, the respective units of insulating material 39 can be omitted.

As an alternative to the heat pipes 36 and the Peltier elements 34 being secured to the cells 32, the heat pipes 36 and Peltier elements 34 can be secured to the optical column (not shown) of which the mirror 31 is a part. The heat pipes 36 are secured to the cooling device 37 via a spring member 38. The cooling device 37 can be configured, for example, to circulate water to cool the heat pipes 36 connected to it. The cooling device 37 also is connected to a controller 50 (not shown in FIG. 8, but see FIG. 9). The controller 50 controllably delivers electrical commands to the respective Peltier elements 34 and electrical command signals to the cooling device 37, according to the temperature distribution of the mirror 31 obtained in advance or measured in real time. Thus, the thermal distribution of the mirror 31 is controlled actively so as to be uniform or have some other desired distribution. Heat produced in the mirror 31 is exhausted outside the optical column via the Peltier elements 34, heat pipes 36, and cooling device 37.

Desirably, all materials used inside the optical column are materials that exhibit an acceptably low level of outgassing in a vacuum environment (if the optical elements in the column normally must be operated in a vacuum environment). Similarly, the materials desirably do not produce contaminants that would compromise performance of the optical elements and other components inside the optical column. To such end, the materials can be coated with a material such as TiN or NiP.

### Fourth Representative Embodiment

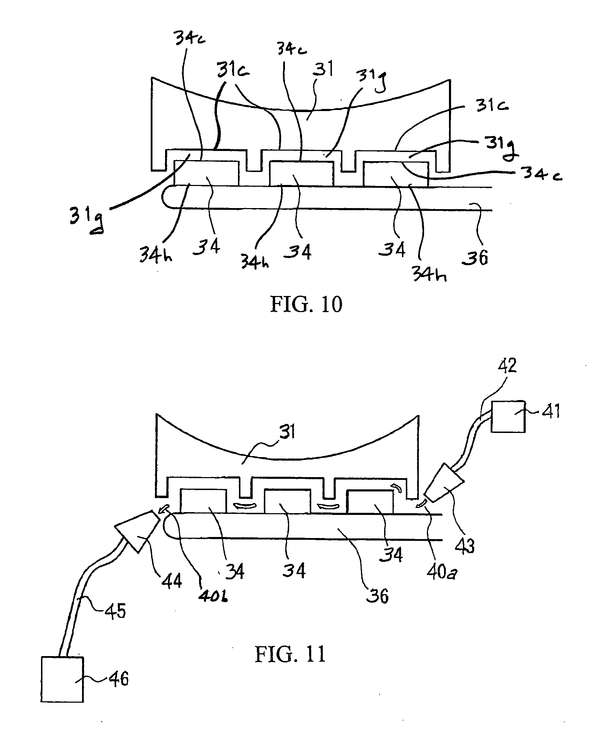

This embodiment is shown in FIG. 10, in which components that are similar to respective components discussed in the third representative embodiment have the same respective reference numerals. This embodiment differs from the third representative embodiment in that, in the instant embodiment, the spring members 35 are eliminated. Otherwise, this embodiment is similar to the third representative embodiment.

Heat from the mirror 31 is transmitted to the Peltier elements 34 by radiation across gaps 31g between the voids 31c and the cold sides 34c of respective electronic cooling elements (Peltier elements) 34. Corresponding heat from the hot sides 34h of the Peltier elements 34 is conducted to outside the optical column via heat pipes 36. In this embodiment, omission of the spring members 35 results in the Peltier elements 34 not physically contacting the mirror 31. Thus, any forces that otherwise would be applied to the mirror 31 from the Peltier elements 34 are isolated from the mirror, which avoids any possible deformation of the mirror by those forces.

In this embodiment as in the third representative embodiment, the Peltier elements 34 have been shown as being associated only with the respective voids 31c in the rear surface 31b of the mirror. However, it will be understood that the Peltier elements can be associated with the side surface 1d and/or front surface 1a as practical or indicated. It also will be understood that, even though multiple Peltier elements 34 are shown (which is advantageous for independent temperature control of respective regions of the mirror), it is possible to use only one Peltier element 34.

### Fifth Representative Embodiment

This embodiment is shown in FIG. 11, which differs from the embodiment of FIG. 10 in that, in the instant embodiment, gas is supplied to the gap between the mirror and Peltier elements 34. Otherwise, this embodiment is similar to the embodiment of FIG. 10.

Specifically, referring to FIG. 11, a gas is released (arrow 40a) from a gas nozzle 43 into the voids 31c in the rear surface 31b of the mirror 31. The gas is routed to the nozzle 43 from a gas supply 41 via a gas conduit 42. The gas passing through the voids 31c is evacuated (arrow 40b) by a suction nozzle 44 or the like connected to a pump 46 via a gas conduit 45. The gas can be, for example, helium, and serves to conduct heat from the mirror 31 to the Peltier elements 34. Note that the evacuated gas can be reused after being brought to a desired temperature.

This embodiment functions best if there is a substantially closed space between the mirror 31 and the Peltier elements 34 and heat pipes 36. If it is difficult to form such a closed space, a wall or guard ring can be placed around the circumference of the mirror 31 to prevent leakage of gas generally to the interior of the vacuum chamber enclosing the optical column.

In FIG. 11 gas is delivered and evacuated from respective sides of the mirror 31. But, this configuration is not intended to be limiting. Gas alternatively may be delivered and evacuated at any suitable location relative to the mirror 31, Peltier elements 34, and heat pipes 36. Also, the number of gas nozzles 43 and suction nozzles 44 is not limited to one each. Multiple nozzles of either or both types can be used.

### Sixth Representative Embodiment

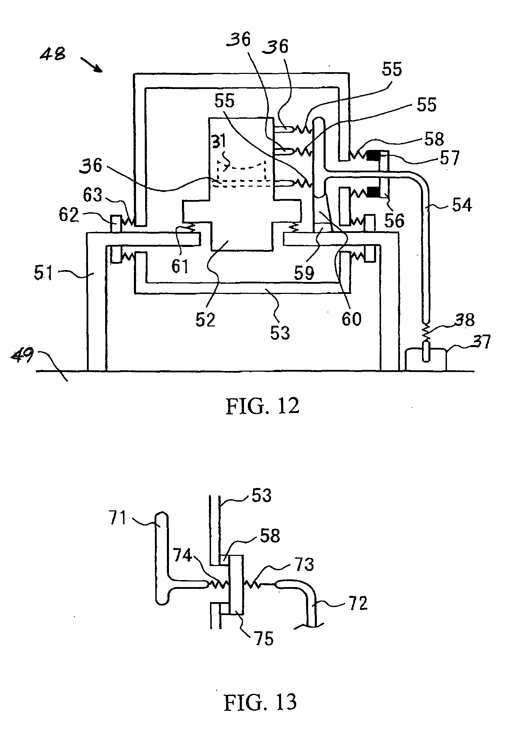

This embodiment is depicted in FIGS. 12 and 13, of which FIG. 12 is a side elevational view schematically depicting an optical system 48 as used in, *e.g.,* a lithography system. The optical system 48 includes optical-element-cooling devices as described in the third and fourth representative embodiments, and includes a base 51 secured to a floor 49 or the like. The base 51 passes through walls of a vacuum chamber 53 so as to support an optical column 52 contained within the vacuum chamber 53. The column 52 is supported relative to the base 51 by spring members 61. The vacuum chamber 53 is secured to the floor 49 by a member (not shown), and the base 51 is connected to the vacuum chamber 53 via flanges 62 and bellows 63. Thus, the vacuum chamber 53 is physically isolated from the base 51. Consequently, any deformation of the vacuum chamber 53 experienced while evacuating the interior of the vacuum chamber to high vacuum is not transmitted to the base 51. Attached to the optical column 52 are multiple optical elements (*e.g.,* mirrors) 31.

Multiple respective primary heat pipes 36 transfer heat from each mirror 31. The primary heat pipes 36 are secured to the optical column 52 in a manner that prevents transmission of vibration, deformation, and heat from the primary heat pipes 36 to the column 52. To such end, the primary heat pipes 36 are connected to a secondary heat pipe 54 via respective spring members 55. The secondary heat pipe 54 is secured to the base 51 via a support member 60 and an insulating member 59 (or by a support member that also serves as an insulating member, which eliminates the need for a separate insulating member 59). Although not shown, the connection between the secondary heat pipe 54 and the base 51 also desirably involves a spring member that blocks transmission of vibration and positional changes. (The support member 60, for example, can be configured with spring-like properties, thereby eliminating the need for a separate spring member.)

Also, the secondary heat pipe 54 is connected to the vacuum chamber 53 via a flange 56, insulating members 57, and bellows 58. Thus, the secondary heat pipe 54 is isolated from the vacuum chamber 53 thermally and with respect to vibration and deformation. By way of example, the vacuum chamber 53, flange 56, and bellows 58 may be made of a material such as stainless steel or a titanium alloy. Heat transmitted via the secondary heat pipe 54 is transmitted to a cooling device 37 via a spring member 38.

Although not shown in FIG. 12, in order to maintain optimal thermal performance, it is desirable that the heat pipes 36, 54 be covered with an insulating material in regions other than locations that are in thermal contact with other members (*e.g.,* locations connected to spring members). Also, compared with the primary heat pipes 36, the secondary heat pipe 54 has a relatively small thermal and physical influence on the mirror 31. Hence, phenomena such as vibration from and between the mirror 31 and secondary heat pipe 54 are alleviated. The secondary heat pipe 54 can be liquid-cooled.

FIG. 13 schematically depicts an exemplary deformation of the system shown in FIG. 12. In FIG. 13, two heat pipes 71, 72 are used instead of the secondary heat pipe 54 used in FIG. 12. The heat pipe 71 is situated inside the vacuum chamber 53 and is connected to a flange 75 of the vacuum chamber 53 by a spring member 74. The heat pipe 72 is situated outside the vacuum chamber 53 and is connected to the flange 75 by a spring member 73. The flange 75 is connected to the wall of the vacuum chamber 53 via a unit of insulating material 58. Heat is transmitted from the respective mirror 31 via the heat pipe 71, the spring member 74, the flange 75, the spring member 73, and the heat pipe 72. Hence, the flange 75 desirably is made of a material having a high thermal conductivity; *e.g.,* stainless steel. Copper, as an exemplary material exhibiting even higher thermal conductivity than stainless steel, can be embedded in the flange if desired or indicated, wherein the heat pipes are connected to the copper.

### Seventh Representative Embodiment

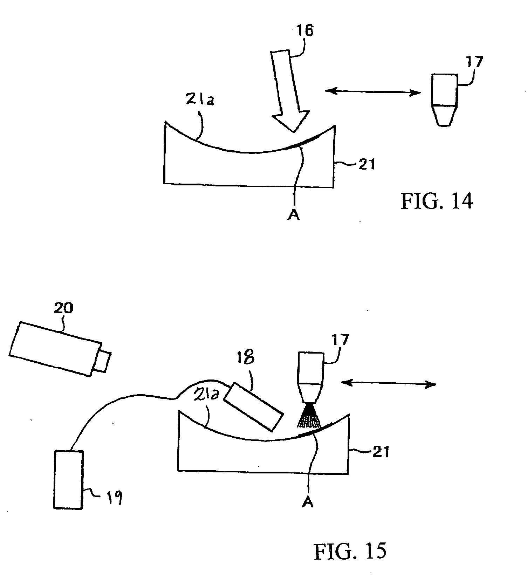

This embodiment is depicted in FIGS. 14 and 15, which depict a mirror 21 (as an exemplary optical element). Referring first to FIG. 14, a light flux 16 (*e.g.,* EUV light) from an upstream illumination-optical system (not shown) is incident on a mirror 21. Some of this incident light is absorbed by the mirror 21, which results in localized heating of the mirror 21 in the irradiated region A of the surface of the mirror 21.

In this embodiment, heat in the mirror 21 is removed by directing a stream of gas onto the surface of the mirror. This gas delivery desirably is performed whenever the mirror 21 is not being used to make an actual exposure, *e.g.,* while performing substrate alignment, while replacing the substrate with a new substrate to be exposed, or during a time dedicated to mirror cooling. Turning to FIG. 15, the mirror 21 is cooled by positioning a gas-delivery nozzle 17 over the reflective surface 21a of the mirror 21, including over the irradiation region A. The gas released from the nozzle 17 desirably is an inert gas such as He or N₂. As the gas is incident on the surface 21 a, the gas conducts away heat from the mirror, thereby achieving cooling of the mirror 21 to a desired temperature. The temperature of the surface 21a can be ascertained by directing an infrared camera 20 or the like onto the surface 21a. Gas release can be halted whenever the mirror 21 is at the desired temperature. Whenever the gas is not being delivered to the mirror 21, the nozzle 17 can be withdrawn from the mirror as shown in FIG. 14, allowing the mirror 21 to be used in its intended manner (*e.g.,* for making lithographic exposures). Control of gas release desirably is achieved using a controller (not shown) that processes data from other systems as well as data from the camera 20.

Desirably, the gas released from the nozzle 17 is evacuated after use. This evacuation desirably is performed in the vicinity of the surface 21 as the gas is being delivered. Evacuation can be performed by any of various intake ports 18 situated and configured for efficiently evacuating the gas. More than one intake port 18 can be used, and the intake ports) desirably are situated in the vicinity of the surface 21 a being exposed to the gas. The intake port 18 desirably is connected to a vacuum pump 19 or the like that aspirates the gas. Further desirably, the gas is recycled for repeated use.

If the mirror 21 is part of the optical system of a lithography system, the mirror 21 can be cooled in the manner described above between exposures of successive substrates, at strategic moments during such exposure, or after several substrates have been exposed. The goal of mirror cooling is to bring the wavefront aberration of the optical system including the mirror 21 (resulting from a temperature increase of the mirror 21) back to within an acceptable operational tolerance. If a threshold mirror temperature is known that will result, when exceeded, in an unacceptable wavefront aberration, cooling can be performed while measuring the temperature of the surface 21a of the mirror 21 using the infrared camera 20. The camera 20 also is useful for obtaining measurements of a temperature distribution on the surface 21a, allowing gas delivery to be directed only to those regions of the surface 21a exhibiting an excessive temperature increase. *I.e.*, mirror cooling can be performed according to the temperature distribution of the surface 21a, and gas delivery can be applied selectively (or more intensively applied) to regions at which the temperature increase is excessive. Other regions exhibiting a lower temperature increases either receive no gas or a reduced amount of gas.

By releasing gas at the reflective surface 21 a of the mirror 21, heat present on the surface is removed by thermal conduction (from the mirror to the gas) and by heat of vaporization. As a result, deformation of the mirror by thermal expansion is reduced substantially so as to allow the mirror to operate within established tolerances of optical performance. Another advantage of this embodiment is that temperature differences between the front and rear surfaces of the mirror are reduced, thereby establishing a more uniform temperature distribution through the thickness dimension of the mirror 21. Also, since the force applied by the stream of gas to the mirror 21 is very weak, the mirror experiences no physical deformation from being cooled.

Whereas FIGS. 14 and 15 depict delivering the gas at the front (reflective) surface 21a of the mirror 21, this is not intended to be limiting. In an alternative embodiment, gas can be delivered only at the rear surface of the mirror or at both the front and rear surfaces.

In addition, mirror cooling according to this embodiment is not limited to optical elements of a projection-optical system, but rather can be applied to an optical element in any optical system, such as an illumination-optical system. Furthermore, the embodiment is not limited to use with respect to mirrors; it can be applied to any of various optical components (including reticles).

### Eighth Representative Embodiment

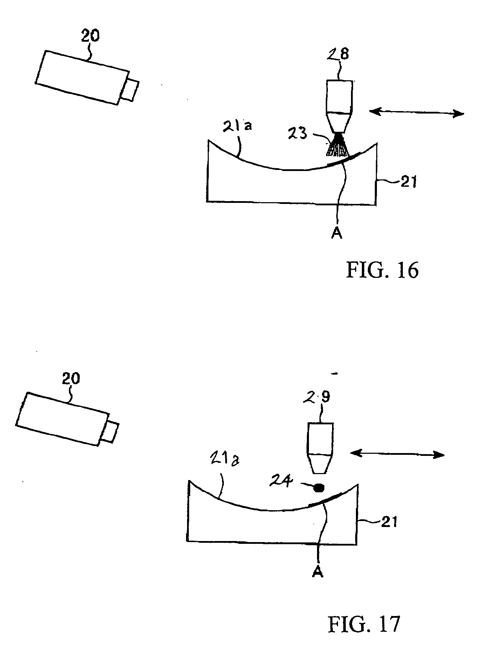

This embodiment is depicted in FIG. 16, in which components that are similar to corresponding components discussed in the seventh representative embodiment have the same respective reference numerals and are not described further. In this embodiment, the mirror 21 is cooled by directing a "spray" 23 of liquid coolant from a nozzle 28 to the surface 21a of the mirror 21. Desirably, the coolant is released from the nozzle 28 as a fine mist. Desirable coolants in this regard include liquid nitrogen, liquid helium, or liquid ethanol. Liquid nitrogen and liquid helium vaporize at room temperature, which prevents the liquids from remaining on the surface 21a (where residual liquid could become a source of contamination). Ethanol is useful in a vacuum environment because it vaporizes instantly in a vacuum and hence does not remain on the surface 21a. Ethanol also is advantageous because it prevents carbon contaminants such as hydrocarbons from adhering to the mirror 21.

### Ninth Representative Embodiment

This embodiment is depicted in FIG. 17, in which components that are similar to corresponding components shown in FIG. 16 have the same reference numerals and are not described further. In this embodiment, the mirror 21 is cooled by directing a liquid 24, released from a nozzle 29, to a selected region A on the surface 21a of the mirror 21. The liquid can be, for example, liquid helium, liquid nitrogen, or liquid ethanol.

### Tenth Representative Embodiment

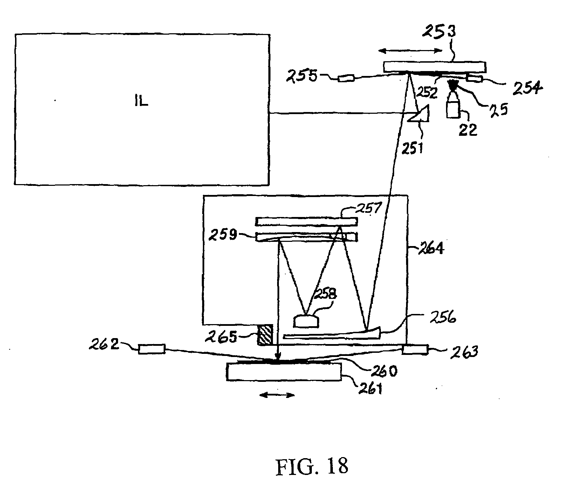

This embodiment is depicted in FIG. 18, and is directed to implementation of the mirror-cooling devices of, for example, the seventh, eighth, or ninth representative embodiments in an optical system, for example a projection-optical system as used in an EUVL system. FIG. 18 is similar in many respects to FIG. 2, and components that are the same in both figures have the same respective reference numerals and are not described further.

EUV light emitted from the illumination system IL is directed by a mirror 251 to a selected region on the surface of a reflective reticle 252, which tends to cause local heating of the reticle 252. To reduce heating of the reticle 252, the reticle is provided with a cooling device that comprises a spray nozzle 22 situated and configured to direct a spray of gas or liquid coolant at the reflective surface of the reticle 252. The spray nozzle 22 is situated at a location at which incident or reflected light is not blocked. By directing the spray 25 at a selected location on the surface of the reticle 252, the reticle 252 is locally cooled, which offsets the irradiation-heating of the reticle 252 and cools the reticle to a desired operating temperature, even during use of the reticle for making exposures. Desirably, the reflective surface of the reticle is observed using an infrared camera or the like (not shown, but see any of FIGS. 15, 16, and 17). Delivery of coolant can be discontinued whenever the surface of the reticle 252 is at a desired temperature at which the reticle exhibits an acceptable level of wavefront aberration. To such end, the infrared camera and spray nozzle 22 can be controlled operationally in a feedback manner by a controller (not shown) as described above.

It also is desirable that the released coolant be actively evacuated after use, as discussed above in connection with FIG. 15.

Cooling of the reticle 252 can be performed at any opportune time, including during use of the reticle for exposure. Exemplary cooling periods can be during periods in which new substrates are positioned for exposure. Cooling of the reticle 252 desirably is continued until the reticle exhibits a profile error, resulting from thermal deformation, that is within an acceptable tolerance. For this purpose, use of an infrared camera can be especially advantageous, as mentioned above, for providing real-time feedback of the cooling process. Use of the camera is advantageous in applying coolant (or more coolant) only to regions of the reticle 252 that actually require cooling, *i.e.,* that are exhibiting a temperature rise in excess of specifications.

### Eleventh Representative Embodiment

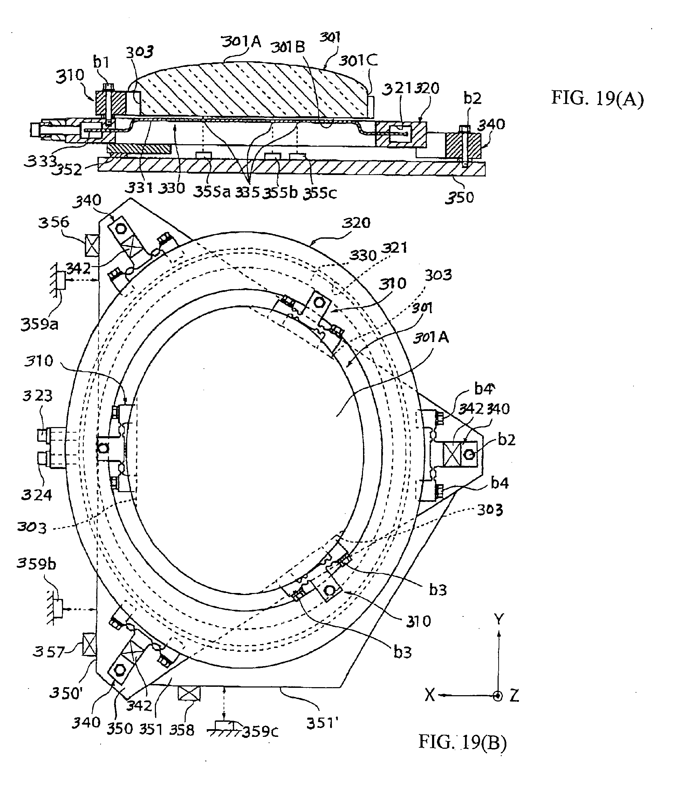

This embodiment is depicted in FIGS. 19(A)-19(B), 20, 21, and 22(A)-22(B). Turning first to FIGS. 19(A)-19(B), a mirror 301 (as an exemplary optical element) is situated inside an optical column (not shown) of an EUV optical system (as a representative optical system). The mirror 301 in this embodiment has a plan profile as shown in FIG. 19(B) and has a thickness of approximately 1-2 cm. (Alternatively, the mirror 301 can have a round or fan-shaped profile, for example.) The mirror 301 has a reflective surface 301A (also termed the "optical-function face"), a rear surface 301B, and a side surface 301C (these other surfaces are also termed "non-optical-function faces"). The mirror 301 defines support cutouts 303 in the side surface 301C. In this embodiment three support cutouts 303 are provided that are roughly equi-angularly displaced relative to each other around the circumference of the mirror 301. The mirror 301 is supported on a ring-like cooling frame 320 via a respective support member 310 provided at each support cutout 303. That is, the mirror 301 is supported at three points on the cooling frame 320 collectively by the support members 310.

For enhanced cooling effect, the gap can be filled with a gas exhibiting a suitably high rater of thermal transfer. To prevent gas leaking from the gap in amounts that could adversely affect the intensity of the EUV light propagating in the EUV optical system, the pressure of the gas should be less than several tens Torr. An exemplary gas for this purpose is helium.

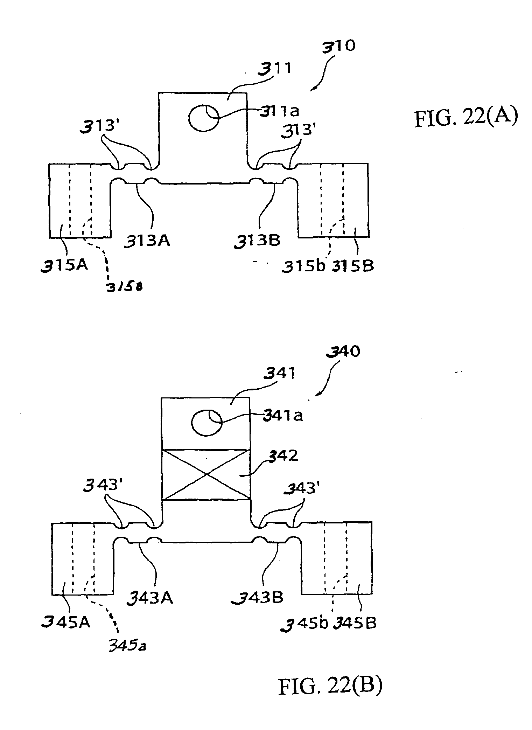

As shown in FIG. 22(A), each support member 310 comprises a fixed part 311, flat springs (or analogous flexible members) 313A, 313B, and link parts 315A, 315B. The support member 310 desirably is formed from a material exhibiting low thermal conduction, such as ZrO₂ or the like, having a thermal conductivity of a few W/m·°K. or less. The fixed part 311 is connected to the cooling frame 320 via a bolt b1 inserted through a bolt hole 311a (FIG. 19(A)). The flat springs 313A, 313B extend laterally in respective opposite directions from one end of the fixed part 311 (FIG. 22(A)). Each flat spring 313A, 313B has a thickness of approximately a few mm in this example. The flat springs are flanked by cutouts 313' that improve the flexibility of the flat springs.

The link parts 315A, 315B are formed integrally and distally of the respective flat springs 313A, 313B. The link parts 315A, 315B are attached to the respective support cutout 303 on the side surface 301C of the mirror 301 using respective linking bolts b3 inserted through respective bolt holes 315a, 315b in the link parts 315A, 315B (see FIG. 19(B)).

The flat springs 313A, 313B in the support members 310 are configured to undergo at least lateral flexure to reduce strains associated with any of various stresses on the mirror, for example: (a) heating of the mirror 301 due to incident EUV light irradiation causes thermal expansion of the mirror, (b) static changes in shape of the mirror 301 due to the mirror having to support its own mass or due to changes in ambient pressure, and (c) dynamic changes in shape of the mirror 301 due to vibrations from the floor supporting the optical system, from movements of a stage associated with the optical system, or from neighboring transport systems (*e.g.*, robots) associated with the optical system. These strains are absorbed by corresponding flexure of the flat springs 313A, 313B. This absorption prevents or substantially reduces strain in the mirror 301 that otherwise would degrade the accuracy of the reflective surface 301A.

The fixed part 311 of each support member 310 is affixed to the cooling frame 320 by a respective bolt b1 (see FIG. 19(A)), as described above. As further shown in FIG. 19(A), the inner circumference of the cooling frame 320 is larger than the outside dimensions of the periphery of the mirror 301. The cooling frame 320 defines a channel 321 in which a cooling medium such as water or fluorinated cooling liquid is conducted. To supply and remove cooling liquid from the channel 321, as shown on the left in FIG. 19(B), an inlet port 323 and outlet port 324, respectively, are provided on the side surface of the cooling frame 320. A coolant-circulation pump (not shown but well understood) is connected to the ports 323 and 324 for continuously circulating the cooling liquid through the channel 321.

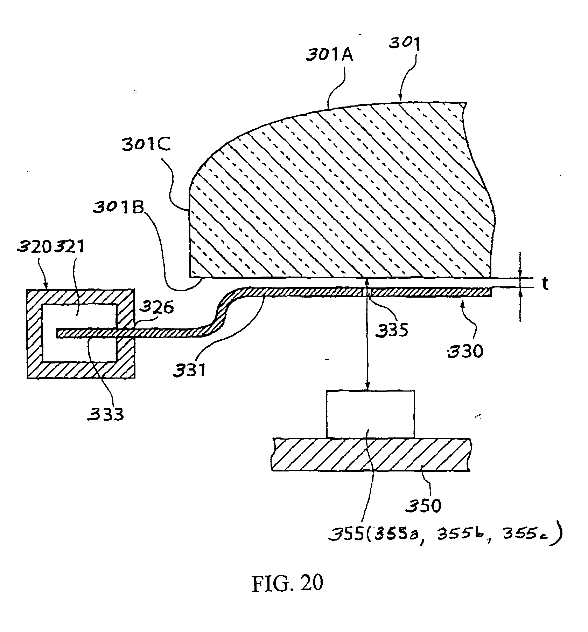

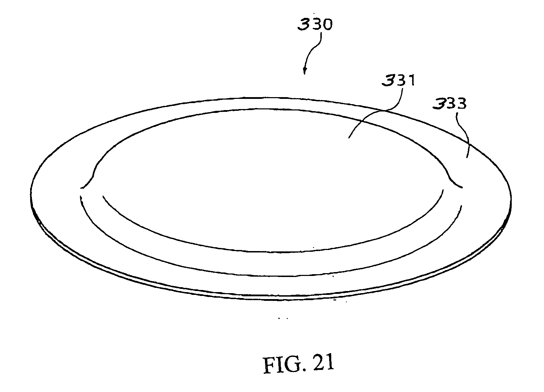

Also shown in FIGS. 19(A) and 20, a heat-conductive plate 330, forming a heat pipe having a thickness of approximately 1 mm in this example, is situated adjacent the rear surface 301B of the mirror 301. Turning now to FIG. 21, the heat-conductive plate 330 in this embodiment has a bowl-like elliptical profile of which the bowl "face" 331 is vertically inverted, by which is meant that the bowl face 331 projects "upward" from a rim-like peripheral edge 333 toward the rear surface 301B. Turning now to FIG. 20, the bowl face 331 is situated and configured so as to define a predetermined gap "t" (approximately 20 µm in this embodiment) between the bowl face 331 and the rear surface 301B. Desirably, a through-hole 335 is defined in the bowl face 331 for passage of a beam of laser light from a laser interferometer 355, described later below. Note that the gap t is shown exaggerated in FIG. 20 for clarity.

The peripheral edge 333 of the heat-conductive plate 330 is inserted into a circumferential slit 326 defined in the inside circumferential surface of the cooling frame 320 (FIG. 20). Thus, the peripheral edge 333 of the heat-conductive plate 330 is contacted by the cooling medium being circulated inside the channel 321. For mechanical and hydraulic integrity, the peripheral edge 333 is soldered or brazed, for example, to the inside circumferential surface of the cooling frame 320.

Whenever heat is generated in the mirror 301 due to incident EUV irradiation, the heat first is radiated across the gap t from the rear surface 301B of the mirror 301 to the bowl face 331 of the heat-conductive plate 330. This transferred heat is conducted via the peripheral edge 333 of the bowl face 331 to the cooling medium circulating inside the channel 321. By conducting this heat away using the cooling medium, thermal deformation of the mirror is reduced. Also, since there is no physical contact between the heat-conductive plate 330 and the mirror 301, no physical forces are applied to the mirror 301 from the plate 330.

Alternatively, instead of having the rear surface 301B separated from the bowl face 331 by a small gap "t", the bowl face 331 can be configured actually to contact the rear surface 301B (*i.e.*, t *=* 0). In such a configuration, heat is transmitted mainly by conduction from the mirror 301 to the heat-conductive plate 330.

The gap t between the rear surface 301B and the heat-conductive plate 330 need not be constant; this gap can be adjustably different at different respective regions of the mirror 301 so as to provide a more tailored temperature control of the reflective surface 301A of the mirror 301. The gap t can be adjusted by configuring the heat-conductive plate 330 to a desired shape, or by attaching respective actuators (*e.g.*, piezoelectric actuators) at predetermined locations on the heat-conductive plate 330. By controlling the temperature distribution of the reflective surface 301A in this manner, the optical performance of the mirror 301 (wavefront aberrations or the like) is improved correspondingly.

Whereas the channel 321 is shown as having a rectangular cross-section (see FIGS. 19(A) and 20), the channel 321 alternatively can have rounded transverse corners for effective suppression of fluid vibrations caused by flow of cooling medium in the channel 321. The flow of the cooling medium desirably is laminar (Reynolds number approximately 1000 or less). To increase heat-removal efficiency, the heat-conductive plate 330 desirably has a large area contacting the cooling medium. To such end, a large portion of the peripheral edge 333 that is inserted into the channel 321 is in contact with the cooling medium, and the transverse dimensions of the channel 321 desirably are large.

Returning to FIGS. 19(A)-19(B), the cooling frame 20 is supported on a mirror base 350, having a plate-like configuration, by three cooling-frame-support members 340. The cooling-frame-support members 340 desirably are disposed, in a circumferential sense, intermediate the positions of the support members 310 holding the mirror 301. A respective insulative spacer 352 (see FIG. 19(A)) desirably is interposed between each cooling-frame-support member 340 and the mirror base 350.

Turning now to FIG. 22(B), each cooling-frame-support member 340 comprises a fixed part 341, an actuator 342, flat springs 343A, 343B, and link parts 345A, 345B. In the same manner as described previously, the cooling-frame-support members 340 are made of a material exhibiting low thermal conductivity, such as ZrO₂, for example. The fixed parts 341 are attached to the mirror base 350 via respective fixing bolts b2 inserted into respective bolt holes 341a (see FIG. 19(A)). The actuators 342 are integral with their respective fixed parts 341. Each actuator 342 comprises a piezoelectric actuator, for example, and is used for finely adjusting the position and orientation of the cooling frame 320 (and mirror 301 mounted thereto) in the Z, θₓ, and θ_{y} directions, based on detection results obtained by the laser interferometer 355, as described later below.

The flat springs 343A, 343B extend laterally from one end of the fixed part 341. The flat springs 343A, 343B each have a thickness of approximately a few mm in this embodiment. Each flat spring 343A, 343B is flanked by respective cutouts 343' to increase flexibility of the flat spring.

The link parts 345A, 345B are formed integrally and distally relative to the flat springs 343A, 343B, respectively. The link parts 345A, 345B are used for mounting the cooling-frame-support members 340 to the side surface of the cooling frame 320. For mounting, linking bolts b4 are inserted into respective bolt holes 345a, 345b (see FIG. 19(B)).

In this embodiment three laser interferometers 355 (355a, 355b, 355c; as exemplary distance sensors) are installed on the "upper" face of the mirror base 350, "below" the mirror 301. As shown in FIG. 20, each interferometer 355a, 355b, 355c produces a respective laser beam that passes through the through-hole 335 defined in the heat-conductive plate 330 and impinges on the rear surface 301B of the mirror 301. Deformations, tilts, and other displacements of the mirror 301 are detected by receiving respective reflected laser beams. Based on data obtained by the interferometers 355a, 355b, 355c, the actuators 342 in the cooling-frame-support members 340 are energized to achieve fine adjustment as required of the position and orientation of the cooling frame 320 (and of the mirror 301 mounted thereon) in the Z, θₓ, and θ_{y} directions.

The mirror base 350 defines an integral extension 351 (see lower part of FIG. 19(B)) having a side surface 351'. Two actuators 356, 357 are attached to the side surface 350' of the mirror base 350, and a single actuator 358 is attached to the side surface 351' of the extension 351. Each actuator 356, 357, 358 comprises a respective piezoelectric actuator, for example, and is used for adjusting the position of the mirror base 350 in the X, Y, and θ_{z} directions. Laser interferometers (position sensors) 359a, 359b, 359c are installed outboard of the mirror base 350, and correspond to respective actuators 356, 357, 358. Based on data obtained by the interferometers 359a, 359b, 359c, the actuators 356, 357, 358 finely adjust the position and orientation of the mirror base 350 in the X, Y, and θ_{z} directions. Thus, by finely adjusting the mirror base 350, corresponding fine adjustments are made of the mirror 301 in the X, Y, and θ_{z} directions.

Thus, this embodiment achieves a six-axis adjustment of the mirror 301 (namely, in the X, Y, Z, θₓ, θ_{y}, θ_{z} directions). The actuator 342 incorporated into the support member 340 achieves fine-adjustment movements in the Z, θₓ, and θ_{y} directions, and the actuators 356, 357, 358 (attached to the mirror base 350 and extension 351) achieve fine-adjustment movements in the X, Y, and θ_{z} directions. As a result of these adjustments, the position and orientation of the mirror 301 can be finely adjusted so as to correct positional errors, while performing mirror cooling.

Whereas the invention has been described in connection with multiple representative embodiments, the invention is not limited to those embodiments. On the contrary, the invention is intended to encompass all modifications, alternatives, and equivalents as may be included within the spirit and scope of the invention, as defined by the appended claims.

## Claims

1. An optical-element-cooling device, comprising:
a heat-receiving plate arranged proximally to a respective optical element along a surface of the optical element at which light directed to the optical element is not incident or outgoing, the heat-receiving plate being configured to receive heat radiating from the optical element; and
a plate-cooling device that removes heat from the heat-receiving plate.

2. The optical-element-cooling device of claim 1, wherein:
the optical element is a mirror having a reflective surface; and
the heat-receiving plate is arranged along at least one surface of the mirror other than the reflective surface of the mirror.

3. The optical-element-cooling device of claim 2, wherein the heat-receiving plate is arranged along a rear surface of the mirror.

4. The optical-element-cooling device of claim 3, wherein the heat-receiving plate additionally is arranged along a side surface of the mirror.

5. The optical-element-cooling device of claim 2, wherein the heat-receiving plate is arranged along a side surface of the mirror.

6. The optical-element-cooling device of claim 1, wherein the heat-receiving plate is arranged conformably to at least a portion of said surface of the optical element at which light directed to the optical element is not incident or outgoing.

7. The optical-element-cooling device of claim 1, wherein the plate-cooling device conformably contacts the heat-receiving plate.

8. The optical-element-cooling device of claim 1, wherein:
the heat-receiving plate is made of a material selected from a group consisting of metals and ceramics; and
the plate-cooling device comprises at least one heat pipe affixed to a surface of the heat-receiving plate facing the optical element.

9. The optical-element-cooling device of claim 8, further comprising a liquid-cooled body to which the at least one heat pipe is connected, the liquid-cooled body removing heat conducted thereto by the at least one heat pipe from the heat-receiving plate.

10. The optical-element-cooling device of claim 1, wherein a surface of the heat-receiving plate facing the optical element is processed so as to increase a heat-absorption efficiency of said surface compared to an otherwise similar non-processed surface.

11. The optical-element-cooling device of claim 10, wherein said surface is processed to provide a ceramic, oxide-, carbide-, or nitride-containing coating on said surface.

12. The optical-element-cooling device of claim 10, wherein said surface is processed to provide an increased surficial roughness or surficial irregularity resulting in an increased heat-absorption area of said surface.

13. The optical-element-cooling device of claim 10, wherein said surface is processed in a spatially distributed manner to provide the increased heat-absorption efficiency to pre-determined locations on said surface.

14. The optical-element-cooling device of claim 1, wherein a surface of the optical element facing the heat-receiving plate is processed so as to increase a heat-radiation efficiency of said surface compared to an otherwise similar non-processed surface.

15. The optical-element-cooling device of claim 14, wherein said surface is processed to provide an increased surficial roughness or surficial irregularity resulting in an increased heat-radiation area of said surface.

16. The optical-element-cooling device of claim 14, wherein said surface is processed in a spatially distributed manner to provide the increased heat-radiation efficiency to pre-determined locations on said surface.

17. The optical-element-cooling device of claim 1, further comprising a heat-proofing device situated relative to the heat-receiving plate and plate-cooling device so as to block thermal radiation from the heat-receiving plate to another optical element and from another optical element to the optical element being cooled by the heat-receiving plate.

18. The optical-element-cooling device of claim 17, wherein the heat-proofing device comprises a second heat-receiving plate and associated heating device that collectively offset heat-sink effects of the heat-receiving plate and plate-cooling device on a neighboring heat-sensitive component.

19. The optical-element-cooling device of claim 18, wherein:
the plate-cooling device conforms to the heat-receiving plate; and
the heat-proofing device conforms to the first heat-receiving plate.

20. The optical-element-cooling device of claim 1, wherein the heat-receiving plate is in contact with said surface of the optical element so as to conduct heat from said surface.

21. The optical-element-cooling device of claim 1, wherein the heat-receiving plate is separated from said surface of the optical element by a defined gap across which heat radiates from the optical element to the heat-receiving plate.

22. The optical-element-cooling device of claim 21, wherein the gap is constant.

23. The optical-element-cooling device of claim 21, wherein the gap is variable so as to provide pre-determined respective greater or lesser heat-transfer rates from selected corresponding locations on said surface of the optical element.

24. The optical-element-cooling device of claim 21, wherein the gap is filled with a gas having high thermal-transfer efficiency and at a pressure of approximately several tens Torr.

25. An optical system, comprising:
an optical element; and
an optical-element-cooling device, as recited in claim 1, situated relative to the optical element so as to cool the optical element.

26. A method for cooling an optical element, comprising:
situating a heat-receiving plate in proximity to an optical element along a surface of the optical element at which light is not incident to or outgoing from the optical element such that the heat-receiving plate receives and absorbs heat from the optical element; and
cooling the heat-receiving plate to remove absorbed heat from the heat-receiving plate.

27. The method of claim 26, wherein the heat-receiving plate is situated so as to absorb heat radiated from the optical element.

28. The method of claim 26, wherein the step of cooling the heat-receiving plate comprises conducting heat from the heat-receiving plate using at least one heat pipe coupled to a liquid-cooled body.

29. The method of claim 28, further comprising the step of connecting the at least one heat pipe to a liquid-cooled body that removes heat from the heat pipe.

30. The method of claim 26, further comprising the step of blocking radiation of heat from the heat-receiving plate to another optical element.

31. The method of claim 26, further comprising the step of blocking a heat-sink effect, resulting from cooling the heat-receiving plate, of the heat-receiving plate on neighboring components.

32. The method of claim 26, wherein the optical system is cooled during actual use of the optical element.

33. An optical system configured for use in a microlithography system, the optical system comprising:
a reflective optical element having a reflective surface that receives incident radiation and reflects at least a portion of the incident radiation;
a heat-receiving plate that receives heat radiating from the reflective optical element, the heat-receiving plate being arranged proximally to the reflective optical element along portions of the optical element other than the reflective surface; and
a plate-cooling device that removes heat from the heat-receiving plate.

34. The optical system of claim 33, wherein the optical element is selected from the group consisting of mirrors and reflective reticles.

35. The optical system of claim 33, wherein the reflective surface of the optical element comprises an EUV-reflective multilayer-coated surface.

36. The optical system of claim 33, further comprising a heat-proofing device situated relative to the heat-receiving plate and the plate-cooling device so as to block thermal radiation from the heat-receiving plate to another optical element and from another optical element to the optical element being cooled by the heat-receiving plate.

37. A projection-optical system configured for use in an EUV lithography system, comprising:
an EUV -reflective multilayer-coated mirror arranged between an EUV-reflective, pattern-defining reticle and a lithographic substrate, to which reticle EUV radiation is selectively irradiated;
a mirror-cooling device associated with the mirror and configured to remove heat from the mirror, the mirror-cooling device comprising a heat-receiving plate and a plate-cooling device collectively arranged proximally along a surface of the mirror at which the EUV radiation is not incident or outgoing, so as to allow the mirror-cooling device to receive heat radiated from the mirror; and
a heat-proofing device situated and configured to block one or more of (i) heat radiation from the plate-cooling device to another optical element of the system, (ii) heat radiation between the plate-cooling device and at least one of the reticle and substrate, and (iii) heat radiation between the plate-cooling device and the mirror.

38. An optical-element-cooling device for cooling an optical element in a vacuum environment, the device comprising:
at least one electronic cooling element having a hot side and a cold side;
a respective spring member arranged between the optical element and the cold side of the electronic cooling element;
at least one heat pipe connected to the hot side of each electronic cooling element and configured for transferring heat away from the hot side and thus from each respective electronic cooling element; and
a heat-pipe-cooling device connected to the at least one heat pipe and configured for removing heat from each heat pipe.

39. The optical-element-cooling device of claim 38, wherein:
the optical element is a reflective optical element having a reflective surface and a non-reflective surface; and
multiple spring members are attached to the non-reflective surface and extend from the non-reflective surface to the at least one heat pipe.

40. The optical-element-cooling device of claim 39, wherein:
the non-reflective surface defines multiple voids in the non-reflective surface;
each void has an associated respective electronic cooling element extending into the void; and
at least one respective spring member is associated with each void so as to connect a portion of the non-reflective surface in the void to a cold side of the respective electronic cooling element.

41. The optical-element-cooling device of claim 40, further comprising a controller connected to each of the electronic cooling elements, the controller being configured to operate each of the electronic cooling elements in a controllable manner so as to provide a respective desired amount of cooling to the respective portion of the non-reflective surface.

42. The optical-element-cooling device of claim 38, further comprising an optical-element-holding device situated and configured to mount the optical element in an optical column.

43. The optical-element-cooling device of claim 42, wherein:
the optical-element-holding device comprises multiple holding cells;
each holding cell is connected to a respective location on the optical element by a respective spring member; and
each holding cell is connected to a heat pipe by a respective spring member.

44. The optical-element-cooling device of claim 43, further comprising a respective unit of thermally insulative material between each holding cell and its respective spring member connecting the holding cell to the heat pipe.

45. The optical-element-cooling device of claim 38, configured to cool a reflective optical element.

46. The optical-element-cooling device of claim 45, wherein the reflective optical element is selected from the group consisting of mirrors and reflective reticles.

47. The optical-element-cooling device of claim 45, wherein the optical element is reflective to incident EUV radiation.

48. An optical system, comprising:
a vacuum chamber;
at least one optical element situated inside the vacuum chamber; and
an optical-element-cooling device, as recited in claim 38, associated with at least one of said optical elements.

49. An optical-element-cooling device for cooling an optical element in a vacuum environment, the device comprising:
at least one electronic cooling element having a hot side and a cold side, each electronic cooling element being situated relative to the optical element such that the respective cold side is adjacent the optical element but separated from the optical element by a gap;
a heat-transfer element situated relative to the hot side of each electronic cooling element and configured to conduct heat away from the hot side; and
a cooling mechanism for removing heat from the heat-transfer element.

50. The optical-element-cooling device of claim 49, wherein each electronic cooling element is a Peltier element.

51. The optical-element-cooling device of claim 49, wherein the optical element is selected from the group consisting of mirrors and reflective reticles.

52. The optical-element-cooling device of claim 49, further comprising:
a gas-delivery device situated and configured to direct a flow of a gas into the gap, the gas serving to conduct heat from the optical element to the at least one cooling element; and
a gas-evacuation device situated and configured to remove the gas from the gap.

53. The optical-element-cooling device of claim 52, wherein:
the gap defines a substantially closed space between the optical element and the electronic cooling elements; and
the gas-evacuation device removes gas from the substantially closed space.

54. The optical-element-cooling device of claim 49, comprising multiple electronic cooling elements situated adjacent respective locations on a surface of the optical element and separated from the respective location by a respective gap.

55. The optical-element-cooling device of claim 54, further comprising a controller connected to each of the electronic cooling elements and configured to control independently each of the cooling elements to provide a respective desired amount of cooling to a respective portion of the optical element.

56. The optical-element-cooling device of claim 49, wherein:
the optical element is a mirror having a reflective surface and a non-reflective surface;
the non-reflective surface defines at least one void in said surface; and
a respective electronic cooling element extends into each void with its respective cold side but is separated from a respective portion of the non-reflective surface in the void by a respective gap.

57. The optical-element-cooling device of claim 56, further comprising:
a gas-delivery device situated and configured to direct a flow of a gas into the gap, the gas serving to conduct heat from the optical element to the at least one cooling element; and
a gas-evacuation device situated and configured to remove the gas from the gap.

58. The optical-element-cooling device of claim 56, wherein the heat-transfer element is a heat pipe.

59. The optical-element-cooling device of claim 56, further comprising at least one spring member connecting the cold side of each electronic cooling element to a respective portion of the non-reflective surface in each void.

60. The optical-element-cooling device of claim 59, wherein each spring member is thermally conductive.

61. The optical-element-cooling device of claim 49, further comprising an optical-element-holding device situated and configured to provide a physical mounting for the optical element in an optical column as the optical-element-cooling device cools the optical element.

62. The optical-element-cooling device of claim 61, wherein:
the optical-element-holding device comprises multiple holding cells; and
each holding cell is connected to the heat-transfer member via a respective spring member.

63. The optical-element-cooling device of claim 62, further comprising a respective unit of thermally insulative material between each holding cell and its respective spring member connecting the holding cell to the heat-transfer member.

64. The optical-element-cooling device of claim 49, further comprising at least one respective spring member connecting the optical element to the at least one electronic cooling element.

65. An optical system, comprising:
a vacuum chamber;
at least one optical element situated inside the vacuum chamber; and
the optical-element-cooling device, as recited in claim 49, associated with at least one of said optical elements.

66. An optical system configured for use in a microlithography system, the optical system comprising:
at least one reflective optical element having a reflective surface that receives incident radiation and reflects at least a portion of the incident radiation; and
a respective optical-element-cooling device associated with at least one of the reflective optical elements, the optical-element-cooling device comprising (i) at least one electronic cooling element having a hot side and a cold side, (ii) a respective spring member arranged between the optical element and the cold side of the electronic cooling element, (iii) at least one heat pipe connected to the hot side of each electronic cooling element and configured for transferring heat away from the hot side and thus from each respective electronic cooling element, and (iv) a heat-pipe-cooling device connected to the at least one heat pipe and configured for removing heat from each heat pipe.

67. The optical system of claim 66, further comprising a vacuum chamber containing the at least one reflective optical element and associated respective optical-element-cooling device.

68. The optical system of claim 66, wherein the at least one optical element is selected from the group consisting of mirrors and reflective reticles.

69. The optical system of claim 66, configured as an illumination-optical system for directing a flux of light to a reticle or as a projection-optical system for directing a flux of light from the reticle to a lithographic substrate.

70. The optical system of claim 69, wherein the reflective surface of the optical element is an EUV-reflective multilayer-coated surface.

71. An optical system configured for use in a microlithography system, the optical system comprising:
at least one reflective optical element having a reflective surface that receives incident radiation and reflects at least a portion of the incident radiation; and
a respective optical-element-cooling device associated with the optical element, the optical-element-cooling device comprising (i) at least one electronic cooling element having a hot side and a cold side, each cooling element being situated relative to the optical element such that the cold side is adjacent the optical element but separated from the optical element by a gap, (ii) a first heat-transfer element situated relative to the hot side of each electronic cooling element and configured to conduct heat away from the hot side, and (iii) a first cooling mechanism for removing heat from the first heat-transfer element.

72. The optical system of claim 71, wherein the optical element is selected from the group consisting of mirrors and reflective reticles.

73. The optical system of claim 71, configured as an illumination-optical system for directing a flux of light to a reticle or as a projection-optical system for directing a flux of light from the reticle to a lithographic substrate.

74. The optical system of claim 71, further comprising a vacuum chamber containing the at least one reflective optical element and associated respective optical-element-cooling device.

75. The optical system of claim 74, further comprising:
a second heat-transfer element arranged so as to extend through a wall of the vacuum chamber;
a spring member connecting the first heat-transfer element to the second heat-transfer element; and
a second cooling mechanism for cooling the second heat-transfer element.

76. The optical system of claim 75, further comprising a flexible member situated between the second heat-transfer element and the wall of the vacuum chamber.

77. The optical system of claim 75, further comprising a unit of thermally insulative material situated between the second heat-transfer element and the wall of the vacuum chamber.

78. An optical system configured for use in a microlithography system, the optical system comprising:
a vacuum chamber;
multiple reflective optical elements situated relative to each other inside the vacuum chamber, each optical element having a respective reflective surface that receives incident radiation and reflects at least a portion of the incident radiation; and
a respective optical-element-cooling device associated with at least one of the optical elements, the optical-element-cooling device comprising (i) a cooling element situated inside the vacuum chamber and configured to remove heat from the respective optical element, (ii) a first heat-transfer element situated inside the vacuum chamber and configured to remove heat from the cooling element, (iii) a second heat-transfer element situated inside the vacuum chamber, (iv) a third heat-transfer element situated outside the vacuum chamber, (v) a first thermally conductive spring member connecting the first heat-transfer element to the second heat-transfer element so as to provide a heat-conduction pathway from the first heat-transfer element to the second heat-transfer element, and (vi) a second thermally conductive spring member connecting the second heat-transfer element to the third heat-transfer element so as to provide a heat-conduction pathway from the second heat-transfer element to the third heat-transfer element.

79. The optical system of claim 78, wherein the second spring member comprises a respective pair of spring-shaped members conjoined at the wall of the vacuum chamber.

80. An extreme-ultraviolet (EUV) lithographic-exposure system, comprising:
an illumination-optical system that guides EUV light to a reflective reticle;
a projection-optical system that guides EUV light from the reflective reticle to a lithographic substrate while transferring an image of a pattern, defined on the reticle, to the substrate, wherein at least one of the illumination-optical system and projection-optical system comprises a mirror having a reflective surface, a rear surface, and a side surface; and
a mirror-cooling device for cooling the mirror, the cooling device comprising a delivery device situated and configured to deliver a cooling medium to at least one of the reflective surface, rear surface, and side surface of the mirror.

81. The system of claim 80, wherein the delivery device comprises a nozzle connected to a supply of the cooling medium.

82. The system of claim 80, further comprising a controller configured to control a timing by which the mirror is cooled using the mirror-cooling device, the controller causing the cooling medium to be delivered from the delivery device whenever the lithographic-exposure system is not being used for making a lithographic exposure.

83. The system of claim 80, further comprising a cooling-medium-evacuation device situated and configured to recover cooling medium delivered from the delivery device.

84. The system of claim 80, wherein the cooling medium is a gas.

85. The system of claim 80, wherein the cooling medium is a liquid.

86. The system of claim 80, wherein the mirror is included in the projection-optical system.

87. The system of claim 80, wherein the mirror is included in the illumination-optical system.

88. A lithographic-exposure system, comprising:
an illumination-optical system that guides EUV light from a source to a reflective surface of a reflective reticle, the reflective surface defining a pattern;
a projection-optical system that guides EUV light from the reflective surface to a lithographic substrate, thereby transferring the pattern to the substrate;
a reticle-cooling device for cooling the reflective reticle, the reticle-cooling device comprising a delivery device situated relative to the reticle and configured to deliver a cooling medium in a manner by which the cooling medium passes over the reflective surface of the reflective reticle.

89. The system of claim 88, further comprising a controller configured to control cooling of the reflective reticle by the reticle-cooling device, in which controlled cooling the delivery device is situated at a position that will not block EUV light incident on the reflective surface of the reticle, at which position the cooling medium is delivered from the delivery device.

90. The system of claim 88, further comprising an evacuation device situated relative to the reticle and delivery device and configured so as to evacuate the cooling medium delivered from the delivery device.

91. The system of claim 88, wherein the cooling medium is a gas or a liquid.

92. The system of claim 91, wherein the cooling medium is helium or nitrogen gas.

93. The system of claim 91, wherein the cooling medium is liquid nitrogen, liquid helium, or ethanol.

94. A method for cooling an EUV-reflective mirror having a front surface and a rear surface, the method comprising delivering a cooling medium into contact with at least one of the front surface or the rear surface of the mirror.

95. The method of claim 94, further comprising the step of evacuating the cooling medium after the cooling medium has contacted the surface.

96. A method for cooling a reflective reticle having a reflective surface that defines a pattern to be transferred to a lithographic substrate by a beam of EUV light, the method comprising releasing a cooling medium at the reticle so as to cause the cooling medium to contact the reflective surface of the reticle.

97. The method of claim 96, further comprising the step of evacuating the cooling medium after the cooling medium has contacted the reflective surface.

98. In a microlithography method in which a pattern, defined on a reflective reticle, is transferred to a lithographic substrate by guiding a beam of EUV light through an illumination-optical system to the reflective reticle and guiding a beam of EUV light through a projection-optical system from the reticle to the substrate, a method for cooling the reflective reticle, comprising:
placing a delivery device relative to the reticle so as not to block EUV light incident on or reflected from the reticle; and
while lithographic exposure is being performed using the reticle, cooling the reticle by releasing a cooling medium from the delivery device at a surface of the reticle.

99. A device for cooling an optical element as the optical element is being supported in an optical column, the optical element having an optical-function surface, a non-optical-function surface, and a peripheral-side surface, the device comprising:
multiple optical-element-support members mounted to respective locations on a surface of the optical element other than the optical-function surface;
a cooling frame to which the optical-element-support members are attached so as to support the optical element relative to the cooling frame; and
a heat-conductive plate disposed along the non-optical-function surface of the optical element, the heat-conductive plate having a periphery that is connected to the cooling frame in a manner allowing the cooling frame to remove heat from the heat-conductive plate, the cooling frame defining a conduit through which a cooling medium is conducted so as to remove heat from the cooling frame and hence from the heat-conductive plate as the optical element is being supported by the cooling frame.

100. The device of claim 99, wherein each optical-element-support member is made of a material having a low coefficient of thermal expansion and that is flexibly deformable in directions normal to the respective location on the peripheral-side surface

101. The system of claim 99, wherein the optical-element-support members are attached to respective locations on the peripheral-side surface.

102. The device of claim 99, wherein the heat-conductive plate is separated from the non-optical-function surface by a defined gap.

103. The device of claim 102, wherein the gap is constant.

104. The device of claim 102, wherein the gap is variable.

105. The device of claim 102, wherein the heat-conductive plate conforms to the shape of the non-optical-function surface.

106. The device of claim 102, wherein the heat-conductive plate has a convex inverted-bowl shape extending toward the non-optical-function surface.

107. The device of claim 102, wherein the gap has a respective dimension at each of multiple locations so as to achieve a respective desired individual rate of thermal transfer at each location from the non-optical-function surface to the heat-conductive plate.

108. The device of claim 107, wherein the individual rates are sufficient to achieve a substantially uniform distribution of temperature at the optical-function surface of the optical element.

109. The device of claim 107, wherein the individual rates are sufficient to achieve a pre-determined distribution of temperature at the optical-function surface of the optical element.

110. The device of claim 99, wherein each optical-element-support member comprises a linking member including a pair of flat springs providing the flexible deformability of the optical-support member.

111. The device of claim 99, further comprising:
a base; and
multiple cooling-frame-support members affixed to the base and extending between the base and respective locations on the cooling frame so as to support the cooling frame relative to the base.

112. The device of claim 111, wherein the cooling-frame-support members support the cooling frame peripherally relative to the base.

113. The device of claim 111, wherein each cooling-frame-support member comprises at least one respective flat spring that is flexibly deformable in a respective direction that is normal to the respective location on the cooling frame.

114. The device of claim 113, wherein each cooling-frame-support member further comprises:
a respective cooling-frame actuator that is movable, when energized, in a direction parallel to an optical axis of the optical element, thereby moving the cooling frame in the direction relative to the base; and
a first sensor situated and configured to detect a distance between the base and the non-optical-function surface of the optical element.

115. The device of claim 114, wherein the first sensor comprises a laser interferometer that directs a beam of laser light through the heat-conductive plate to the optical element.

116. The device of claim 114, wherein the first sensor is configured to provide feedback position data to the respective cooling-frame actuator.

117. The device of claim 114, wherein the base is mounted to the optical column.

118. The device of claim 117, further comprising:
at least one base actuator that is movable in at least one orthogonal direction perpendicular to the optical axis of the optical element, thereby moving the base and cooling frame in the orthogonal direction relative to the optical column; and
a second sensor situated and configured to detect a displacement of the base relative to the optical column.

119. The device of claim 118, wherein the second sensor is configured to provide feedback position data to the respective base actuator.

120. An optical system, comprising:
an optical element; and
an optical-element-cooling and support device as recited in claim 99.

121. An optical system configured for use in a microlithography system, the optical system comprising:
an optical column;
a reflective optical element having an optical-function surface that receives radiation and reflects at least a portion of the incident radiation; and
an optical-element-cooling device for cooling the optical element as the optical element is being supported in the optical column, the optical-element-cooling device comprising (i) multiple optical-element-support members mounted to respective locations on a surface of the optical element other than the optical-function surface, (ii) a cooling frame to which the optical-element-support members are attached so as to support the optical element relative to the cooling frame, and (iii) a heat-conductive plate disposed along the non-optical-function surface of the optical element, the heat-conductive plate having a periphery that is connected to the cooling frame in a manner allowing the cooling frame to remove heat from the heat-conductive plate, the cooling frame defining a conduit through which a cooling medium is conducted so as to remove heat from the cooling frame and hence from the heat-conductive plate as the optical element is being supported by the cooling frame.

122. The system of claim 121, wherein the optical element is selected from the group consisting of mirrors and reflective reticles.

123. The system of claim 122, wherein the reflective surface of the optical element comprises an EUV-reflective multilayer-coated surface.

124. The system of claim 121, further comprising a vacuum chamber enclosing the optical column.

125. A method for cooling an EUV-reflective optical element as the optical element is being supported in an optical column, the optical element having an optical-function surface and a non-optical-function surface, the method comprising the steps:
attaching the optical element to a cooling frame by multiple optical-element support members extending from the cooling frame to respective locations on the non-optical-function surface, the cooling frame defining a fluid conduit;
placing a heat-conductive member, connected to the cooling frame, relative to the non-optical-function surface and separated from the non-optical-function surface by a gap so as to allow the heat-conductive member to absorb heat radiating across the gap from the optical element; and
circulating a cooling fluid through the fluid conduit while conducting heat from the heat-conductive member to the cooling frame, thereby transferring heat from the heat-conductive member to the cooling frame and to the cooling fluid.

126. The method of claim 125, further comprising the steps of:
mounting a cooling frame to a base that is connected to the optical column;
detecting a position of the cooling frame, and hence of the optical element, relative to the base; and
based on the detected position of the cooling frame, adjusting the position of the cooling frame relative to the base.

127. The method of claim 126, further comprising the steps of:
detecting a position of the base relative to the optical column; and
based on the detected position of the base, adjusting the position of the base relative to the optical column.
